(19)
Europäisches
Patentamt
European
Patent Office
Office européen
des brevets

(11) **EP 4 343 816 A1**

(12) **EUROPEAN PATENT APPLICATION**

(43) Date of publication:
**27.03.2024   Bulletin 2024/13**

(21) Application number: **23197771.1**

(22) Date of filing: **15.09.2023**

(51) International Patent Classification (IPC):
*H01L 21/02* $^{(2006.01)}$   *H01L 21/32* $^{(2006.01)}$
*H01L 21/30* $^{(2006.01)}$   *H01L 21/3105* $^{(2006.01)}$

(52) Cooperative Patent Classification (CPC):
**H01L 21/0228; H01L 21/02126; H01L 21/02315;
H01L 21/32;** H01L 21/02252; H01L 21/30;
H01L 21/3105

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **26.09.2022   JP 2022152708**

(71) Applicant: **Kokusai Electric Corp.
Tokyo 1010045 (JP)**

(72) Inventors:
• **DEGAI, Motomu
Toyama-shi, 9392393 (JP)**
• **NAKATANI, Kimihiko
Toyama-shi, 9392393 (JP)**
• **YAMAKADO, Yuki
Toyama-shi, 9392393 (JP)**
• **KIMURA, Shoji
Toyama-shi, 9392393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, SUBSTRATE  PROCESSING SYSTEM, AND PROGRAM**

(57)       There is provided a technique that includes: (a) performing: (ai) exciting a first oxi dizing agent and a first reducing agent into a plasma state and supplying the first oxidizi ng agent and the first reducing agent thus excited to a substrate, which includes a first su rface and a second surface; and ($a_2$) exciting a second reducing agent into a plasma state and supplying the second reducing agent thus excited to the substrate; and (b) heat-treat ing the substrate subjected to (a).

FIG. 4

EP 4 343 816 A1

**Description**

CROSS-REFERENCE TO RELATED APPLICATION

This application is based upon and claims the benefit of priority from Japanese Patent Application No. 2022-152708, filed on September 26, 2022, the entire contents of which are incorporated herein by reference.

TECHNICAL FIELD

The present disclosure relates to a method of processing a substrate, a method of manufacturing a semiconductor device, a substrate processing system, and a program.

BACKGROUND

In the related art, as a process of manufacturing a semiconductor device, a process of selectively growing and forming a film on a specific surface among a plurality of types of surfaces of a substrate in which materials exposed on the surfaces are different (hereinafter, this process is also referred to as selective growth or selective film formation) may be carried out.

SUMMARY

Some embodiments of the present disclosure provide a technique capable of selectively forming a film on a desired surface with high precision.

According to some embodiments of the present disclosure, there is provided a technique that includes: (a) performing: (a1) exciting a first oxidizing agent and a first reducing agent into a plasma state and supplying the first oxidizing agent and the first reducing agent thus excited to a substrate, which includes a first surface and a second surface; and (a2) exciting a second reducing agent into a plasma state and supplying the second reducing agent thus excited to the substrate; and (b) heat-treating the substrate subjected to (a).

BRIEF DESCRIPTION OF DRAWINGS

The accompanying drawings, which are incorporated in and constitute a part of the specification, illustrate embodiments of the present disclosure.

FIG. 1 is a schematic configuration view of a vertical process furnace of a substrate processing apparatus suitably used in embodiments of the present disclosure, in which a portion of the process furnace is shown in a vertical cross section.
FIG. 2 is a schematic configuration view of the vertical process furnace of the substrate processing apparatus suitably used in the embodiments of the present disclosure, in which a portion of the process furnace is shown in a cross section taken along line A-A in FIG. 1.
FIG. 3 is a schematic configuration diagram of a controller of a substrate processing apparatus suitably used in the embodiments of the present disclosure, in which a control system of the controller is shown in a block diagram.
FIG. 4 is a diagram showing a processing sequence in the embodiments of the present disclosure.

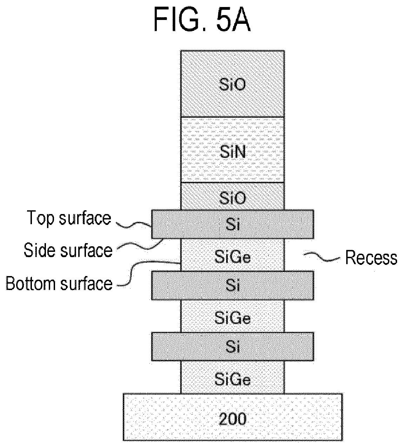

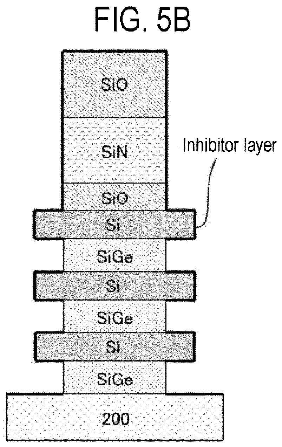

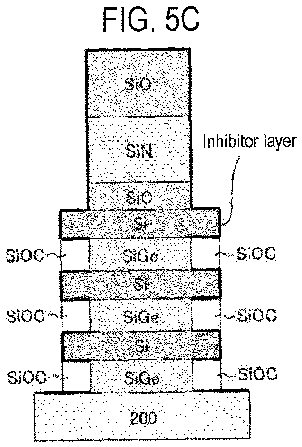

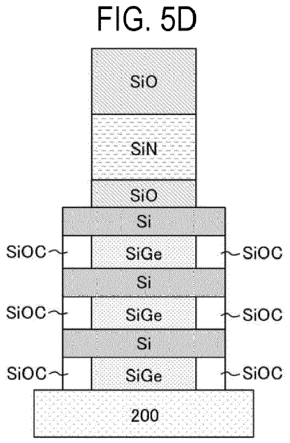

FIG. 5A is a partially-enlarged cross-sectional view of a surface of a substrate in which a laminated structure formed by alternately laminating a first material (SiGe) and a second material (Si) is formed on the surface of the substrate, a fourth material (SiO), a third material (SiN), and the fourth material (SiO) are laminated on the laminated structure, and a recess whose depth direction is a direction (horizontal direction) parallel to the surface of the substrate is formed in a side wall of the laminated structure by partially removing a portion, which is constituted by the first material, of the side wall of the laminated structure of the first material and the second material. FIG. 5B is a partially-enlarged cross-sectional view of the surface of the substrate after an inhibitor layer is formed on the substrate including, on its surface, the structure in FIG. 5A, according to a processing sequence in the embodiments of the present disclosure. FIG. 5C is a partially-enlarged cross-sectional view of the surface of the substrate after a film (SiOC) is formed after the inhibitor layer is formed, on the substrate including, on its surface, the structure in FIG. 5A, according to a processing sequence in the embodiments of the present disclosure. FIG. 5D is a partially-enlarged cross-sectional view of the surface of the substrate after heat treatment is performed after the inhibitor layer and the film (SiOC) are formed, on the substrate including, on its surface, the structure in FIG. 5A, according to a processing sequence in the embodiments of the present disclosure.

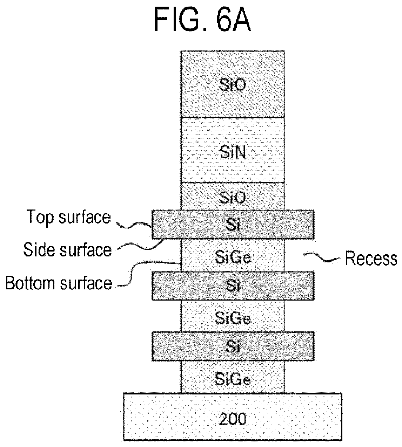

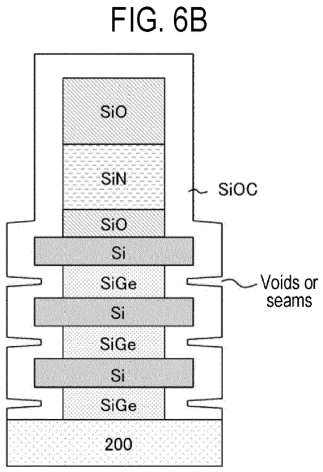

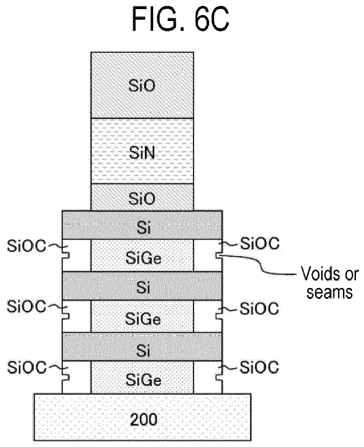

FIG. 6A is a partially-enlarged cross-sectional view of the surface of a substrate in which a laminated structure formed by alternately laminating a first material (SiGe) and a second material (Si) is formed on the surface of the substrate, a fourth material (SiO), a third material (SiN), and the fourth material (SiO) are laminated on the laminated structure, and a recess whose depth direction is a direction (horizontal direction) parallel to the surface of the substrate is formed in a side wall of the laminated structure by partially removing a portion, which is constituted by the first material, of the side wall of the laminated structure of the first material and the second material. FIG. 6B is a partially-enlarged cross-sectional view of the surface of the substrate after a film (SiOC) is formed on the substrate including, on its surface, the structure in FIG. 6A, according to a film-forming method in the related art. FIG. 6C is a partially-enlarged cross-sectional view of the surface of the substrate after an extra film formed on a top surface of the recess, and the like is removed by performing an etching process on the substrate including, on its surface, the structure in FIG. 6B.

FIG. 7 is a block diagram for explaining an example of a substrate processing system suitably used in other embodiments of the present disclosure.

FIG. 8 is a block diagram for explaining another example of a substrate processing system suitably used in other embodiments of the present disclosure.

FIG. 9 is a cross-sectional TEM image of an evaluation sample 1 in an Example.

FIG. 10 is a cross-sectional TEM image of an evaluation sample 2 in the Example.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to unnecessarily obscure aspects of the various embodiments.

<Embodiments of the Present Disclosure>

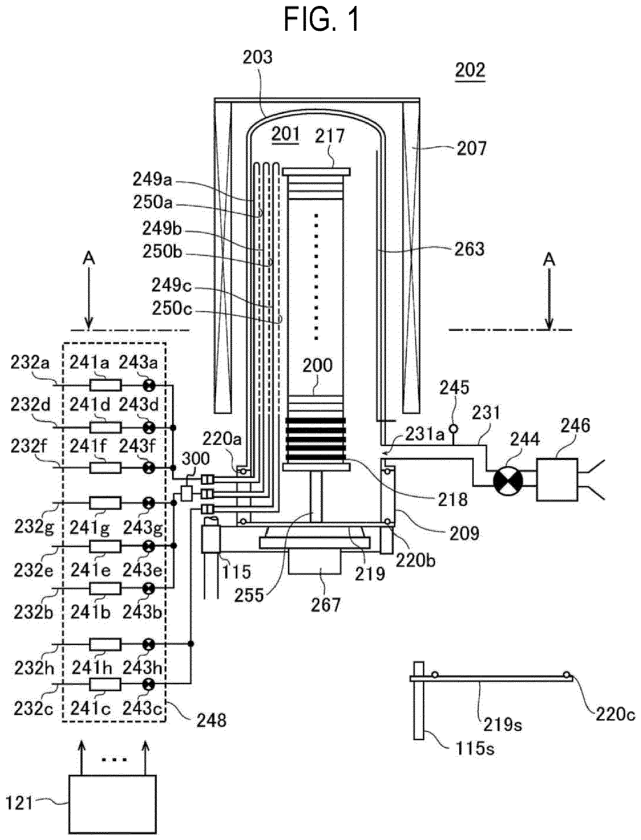

Embodiments of the present disclosure will now be described mainly with reference to FIGS. 1 to 4 and 5A to 5D. The drawings used in the following description are schematic, and dimensional relationships, ratios, and the like of various components shown in figures may not match actual ones. Further, dimensional relationships, ratios, and the like of various components among plural figures may not match one another.

(1) Configuration of Substrate Processing Apparatus (Substrate Processing System)

As shown in FIG. 1, a process furnace 202 includes a heater 207 as a temperature regulator (a heating part). The heater 207 is formed in a cylindrical shape and is supported by a holding plate so as to be vertically installed. The heater 207 also functions as an activator (an exciter) configured to thermally activate (excite) a gas.

A reaction tube 203 is disposed inside the heater 207 to be concentric with the heater 207. The reaction tube 203 is made of, for example, a heat resistant material such as quartz ($SiO_2$) or silicon carbide (SiC), and is formed in a cylindrical shape with its upper end closed and its lower end opened. A manifold 209 is disposed to be concentric with the reaction tube 203 under the reaction tube 203. The manifold 209 is made of, for example, a metal material such as stainless steel (SUS), and is formed in a cylindrical shape with both of its upper and lower ends opened. An upper end side of the manifold 209 engages with a lower end side of the reaction tube 203 so as to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed in a hollow cylindrical area of the process container. The process chamber 201 is configured to be capable of accommodating wafers 200 as substrates. Processing on the wafers 200 is performed in the process chamber 201.

Nozzles 249a to 249c as first to third suppliers are installed in the process chamber 201 so as to penetrate through a sidewall of the manifold 209. The nozzles 249a to 249c are also referred to as first to third nozzles, respectively. The nozzles 249a to 249c are made of, for example, a heat resistant material such as quartz or SiC. Gas supply pipes 232a to 232c are connected to the nozzles 249a to 249c, respectively. The nozzles 249a to 249c are different nozzles, and each of the nozzles 249a and 249c is installed adjacent to the nozzle 249b.

Mass flow controllers (MFCs) 241a to 241c, which are flow rate controllers (flow rate control parts), and valves 243a to 243c, which are opening/closing valves, are installed at the gas supply pipes 232a to 232c, respectively, sequentially from the upstream side of a gas flow. Each of gas supply pipes 232d and 232f is connected to the gas supply pipe 232a at the downstream side of the valves 243a. Each of gas supply pipes 232e and 232g is connected to the gas supply pipe 232b at the downstream side of the valves 243b. A gas supply pipe 232h is connected to the gas supply pipe 232c at the downstream side of the valves 243c. MFCs 241d to 241h and valves 243d to 243h are installed at the gas supply pipes 232d to 232h, respectively, sequentially from the upstream side of a gas flow. The gas supply pipes 232a to 232h are made of, for example, a metal material such as SUS.

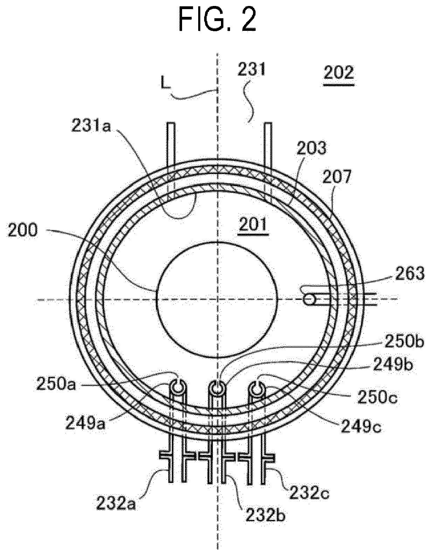

As shown in FIG. 2, each of the nozzles 249a to 249c is installed in an annular space in a plane view between an inner wall of the reaction tube 203 and the wafers 200 so as to extend upward from a lower side to an upper side of the inner wall of the reaction tube 203, that is, along an arrangement direction of the wafers 200. Specifically, each of the nozzles 249a to 249c is installed in a region horizontally surrounding a wafer arrangement region in which the wafers 200 are arranged at a lateral side of the wafer arrangement region, along the wafer arrangement region. In the plane view, the nozzle 249b is disposed so as to face an exhaust port 231a described below on a straight line across centers of the wafers 200 loaded into the process chamber 201, which are interposed therebetween. The nozzles 249a and 249c are arranged to sandwich a straight line L passing through the nozzle 249b and a center of the exhaust port 231a from both sides along the inner wall of the reaction tube 203 (outer peripheral sides of the wafers 200). The straight line L is also a straight line passing through the nozzle 249b and the centers of the wafers 200. That is, it may be said that the nozzle 249c is installed opposite the nozzle 249a with the straight line L interposed therebetween. The nozzles 249a and 249c are arranged in a line-symmetry relationship with the straight line L as an axis of symmetry. Gas supply holes 250a to 250c configured to supply a gas are formed on the side surfaces of the nozzles 249a to 249c, respectively. Each of the gas supply holes 250a to 250c is opened to oppose (face) the exhaust port 231a in the plane view, which enables the gas to be supplied toward the wafers 200. A plurality of gas supply holes 250a to 250c are formed from the lower side to the upper side of the reaction tube 203.

A modifying agent (modifying gas) is supplied from the gas supply pipe 232a into the process chamber 201 via the MFC 241a, the valve 243a, and the nozzle 249a.

A precursor (precursor gas), which is a film-forming agent (film-forming gas), and a reducing agent (reducing gas) are supplied from the gas supply pipe 232b into the process chamber 201 via the MFC 241b, the valve 243b, and the nozzle 249b.

A reactant (reaction gas), which is a film-forming agents (film-forming gas), are supplied from the gas supply pipe 232c into the process chamber 201 via the MFC 241c, the valve 243c, and the nozzle 249c.

A catalyst (catalyst gas), which is a film-forming agents (film-forming gas), are supplied from the gas supply pipe 232d into the process chamber 201 via the MFC 241d, the valve 243d, the gas supply pipe 232a, and the nozzle 249a.

An etching agent (etching gas) and an oxidizing agent (oxidizing gas) are supplied from the gas supply pipe 232e into the process chamber 201 via the MFC 241e, the valve 243e, the gas supply pipe 232b, and the nozzle 249b.

An inert gas is supplied from the gas supply pipes 232f to 232h into the process chamber 201 via the MFCs 241f to 241h, the valves 243f to 243h, the gas supply pipes 232a to 232c, and the nozzles 249a to 249c, respectively. The inert gas acts as a purge gas, a carrier gas, a dilution gas, or the like.

A remote plasma unit (RPU) 300, as a plasma exciter (plasma generator) configured to excite a gas into a plasma state, is installed at the downstream side of a connector of the gas supply pipe 232b with the gas supply pipe 232g. Exciting a gas into a plasma state is also simply referred to as plasma excitation. By applying radio-frequency (RF) power to the RPU 300, it is possible to turn a gas inside the RPU 300 into plasma to excite the gas, that is, to excite the gas into a plasma state. As a plasma generation method, a capacitively-coupled plasma (abbreviation: CCP) method may be used, or an inductively-coupled plasma (abbreviation: ICP) method may be used. The RPU 300 is configured to be able to excite the reducing agent, the oxidizing agent, and the inert gas supplied from the gas supply pipes 232b, 232e, and 232g into a plasma state and supply them into the process chamber 201.

A modifying agent supply system mainly includes the gas supply pipe 232a, the MFC 241a, and the valve 243a. A precursor supply system and a reducing agent supply system mainly include the gas supply pipe 232b, the MFC 241b, and the valve 243b. A reactant supply system mainly includes the gas supply pipe 232c, the MFC 241c, and the valve 243c. A catalyst supply system mainly includes the gas supply pipe 232d, the MFC 241d, and the valve 243d. An etching agent supply system and an oxidizing agent supply system mainly include the gas supply pipe 232e, the MFC 241e, and the valve 243e. An inert gas supply system mainly includes the gas supply pipes 232f to 232h, the MFCs 241f to 241h, and the valves 243f to 243h. Each or both of the precursor supply system and the reactant supply system are also referred to as a film-forming agent supply system. Each or the entirety of the precursor supply system, the reactant supply system, and the catalyst supply system are also referred to as a film-forming agent supply system.

One or the entirety of the above-described various supply systems may be constituted as an integrated supply system 248 in which the valves 243a to 243h, the MFCs 241a to 241h, and so on are integrated. The integrated supply system 248 is connected to each of the gas supply pipes 232a to 232h. In addition, the integrated supply system 248 is configured such that operations of supplying various materials (various gases) into the gas supply pipes 232a to 232h (that is, the opening/closing operation of the valves 243a to 243h, the flow rate regulating operation by the MFCs 241a to 241h, and the like) are controlled by a controller 121 described below. The integrated supply system 248 is constituted as an integral or detachable integrated unit, and may be attached to or detached from the gas supply pipes 232a to 232h and the like on an integrated unit basis, such that maintenance, replacement, extension, and the like of the integrated supply system 248 may be performed on an integrated unit basis.

The exhaust port 231a configured to exhaust an internal atmosphere of the process chamber 201 is provided below the sidewall of the reaction tube 203. As shown in FIG. 2, in the plane view, the exhaust port 231a is provided at a position opposing (facing) the nozzles 249a to 249c (the gas supply holes 250a to 250c) with the wafers 200 interposed therebetween. The exhaust port 231a may be provided from a lower side to an upper side of the sidewall of the reaction tube 203, that is, along the wafer arrangement region. An exhaust pipe 231 is connected to the exhaust port 231a. A vacuum pump 246 as a vacuum exhauster, is connected to the exhaust pipe 231 via a pressure sensor 245, which is a pressure detector (pressure detection part) configured to detect the internal pressure of the process chamber 201, and an auto pressure controller (APC) valve 244, which is a pressure regulator (pressure regulation part). The APC valve 244 is configured to be capable of performing or stopping a vacuum exhausting operation in the process chamber 201 by opening/closing the valve while the vacuum pump 246 is actuated, and is also configured to be capable of regulating the internal pressure of the process chamber 201 by adjusting an opening state of the valve based on pressure information detected by the pressure sensor 245 while the vacuum pump 246 is actuated. An exhaust system mainly includes the exhaust pipe 231, the APC valve 244, and the pressure sensor 245. The exhaust system may include the vacuum pump 246.

A seal cap 219, which serves as a furnace opening lid configured to be capable of hermetically sealing a lower end opening of the manifold 209, is installed under the manifold 209. The seal cap 219 is made of, for example, a metal material such as SUS, and is formed in a disc shape. An O-ring 220b, which is a seal making contact with the lower end of the manifold 209, is installed on an upper surface of the seal cap 219. A rotator 267 configured to rotate a boat 217 described below, is installed under the seal cap 219. A rotary shaft 255 of the rotator 267 is connected to the boat 217 through the seal cap 219. The rotator 267 is configured to rotate the wafers 200 by rotating the boat 217. The seal cap 219 is configured to be vertically moved up or down by a boat elevator 115 which is an elevator installed outside the reaction tube 203. The boat elevator 115 is constituted as a transfer apparatus (transfer equipment) configured to load or unload (transfer) the wafers 200 into or out of the process chamber 201 by moving the seal cap 219 up or down.

A shutter 219s, which serves as a furnace opening lid configured to be capable of hermetically sealing a lower end opening of the manifold 209 in a state where the seal cap 219 is lowered and the boat 217 is unloaded from the process chamber 201, is installed under the manifold 209. The shutter 219s is made of, for example, a metal material such as SUS, and is formed in a disc shape. An O-ring 220c, which is a seal making contact with the lower end of the manifold 209, is installed on an upper surface of the shutter 219s. The opening/closing operation (such as elevation operation, rotation operation, or the like) of the shutter 219s is controlled by a shutter opening/closing equipment 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. Heat insulating plates 218 made of, for example, a heat resistant material such as quartz or SiC are installed below the boat 217 in multiple stages.

A temperature sensor 263 serving as a temperature detector is installed in the reaction tube 203. Based on temperature information detected by the temperature sensor 263, a state of supplying electric power to the heater 207 is regulated such that a temperature distribution inside the process chamber 201 becomes a desired temperature distribution. The temperature sensor 263 is installed along the inner wall of the reaction tube 203.

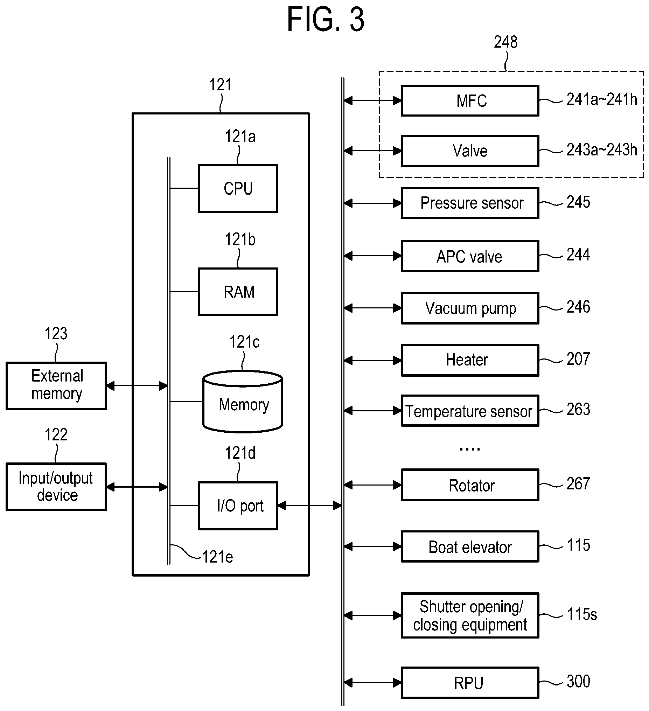

As shown in FIG. 3, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 including, e.g., a touch panel or the like, is connected to the controller 121. Further, an external memory 123 may be connected to the controller 121.

The memory 121c includes, for example, a flash memory, a hard disk drive (HDD), a solid state drive (SSD), or the like. A control program that controls operations of a substrate processing apparatus, a process recipe in which sequences and conditions of substrate processing described below are written, and the like are readably stored in the memory 121c. The process recipe functions as a program configured to cause, by the controller 121, the substrate processing apparatus (substrate processing system) to execute each sequence in the substrate processing described below, to obtain an expected result. Hereinafter, the process recipe and the control program may be generally and simply referred to as a "program." Furthermore, the process recipe may be simply referred to as a "recipe." When the term "program" is used herein, it may indicate a case of including the recipe, a case of including the control program, or a case of including both the recipe and the control program. The RAM 121b is constituted as a memory area (work area) in which programs or data read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opening/closing equipment 115s, the RPU 300, and so on.

The CPU 121a is configured to be capable of reading and executing the control program from the memory 121c. The CPU 121a is also configured to be capable of reading the recipe from the memory 121c according to an input of an operation command from the input/output device 122. The CPU 121a is configured to be capable of controlling the flow rate regulating operation of various kinds of materials (gases) by the MFCs 241a to 241h, the opening/closing operation of the valves 243a to 243h, the opening/closing operation of the APC valve 244, the pressure regulating operation performed by the APC valve 244 based on the pressure sensor 245, the actuating and stopping operation of the vacuum pump 246, the temperature regulating operation performed by the heater 207 based on the temperature sensor 263, the operation of rotating the boat 217 with the rotator 267 and adjusting a rotation speed of the boat 217, the operation of moving the boat 217 up or down by the boat elevator 115, the opening/closing operation of the shutter 219s by the shutter opening/closing equipment 115s, the operation of exciting the gas into the plasma by the RPU 300, and so on, according to contents of the read recipe.

The controller 121 may be constituted by installing, on the computer, the aforementioned program recorded and stored in the external memory 123. Examples of the external memory 123 may include a magnetic disk such as a HDD, an optical disc such as a CD, a magneto-optical disc such as a MO, a semiconductor memory such as a USB memory or a SSD, and the like. The memory 121c or the external memory 123 is constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Furthermore, the program may be provided to the computer by using communication means or unit such as the Internet or a dedicated line, instead of using the external memory 123.

(2) Substrate Processing Process

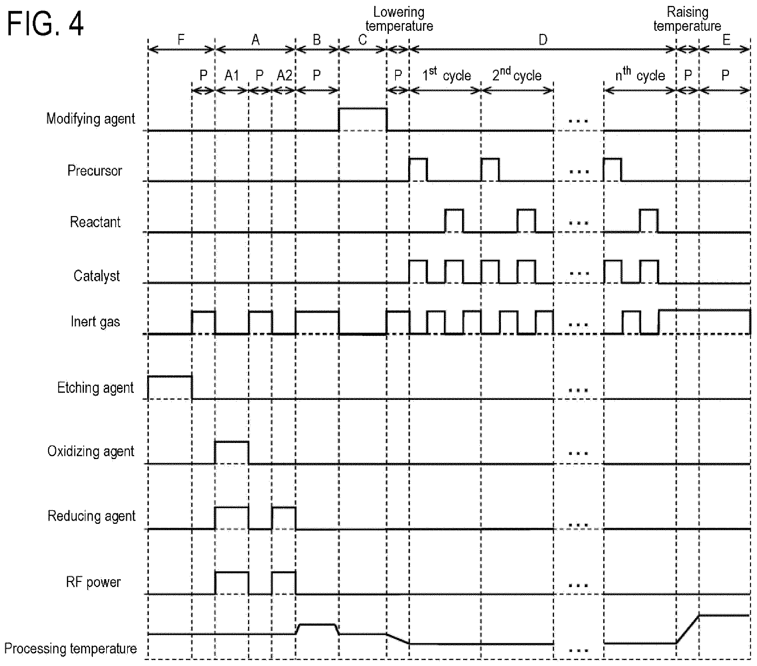

As a process of manufacturing a semiconductor device in which the above-described substrate processing apparatus (substrate processing system) is used, an example of a method of processing a substrate, that is, a processing sequence of forming a film on a first surface of a wafer 200 as a substrate of the first surface and a second surface of the wafer 200, will be described mainly with reference to FIGS. 4 and 5A to 5D. Herein, an example of a processing sequence of forming a film on the first surface among the first, second, third, and fourth surfaces of the wafer 200 will be described. In the following descriptions, operations of the respective components constituting the substrate processing apparatus are controlled by the controller 121.

Here, as shown in FIG. 5A, a recess whose bottom surface is constituted by a first material containing a first element, whose side surface and top surface are constituted by a second material containing a second element different from the first element, and whose depth direction is a direction (horizontal direction) parallel to the surface of the wafer 200 is formed on the surface of the wafer 200. The first surface is the bottom surface of the recess, and the second surface is the side surface of the recess or the side surface and top surface of the recess. Further, the third surface and the fourth surface are surfaces of portions of the surface of the wafer 200 other than from the recess. The third surface is constituted by a third material containing a third element different from the first element and the second element, and the fourth surface is constituted by a fourth material containing a fourth element different from the first element, the second element, and the third element. Further, the first element includes a Group XIV element, the second element includes a Group XIV element, the third element includes a Group XV element, and the fourth element includes a Group XVI element.

FIG. 5A shows an example in which the first element is germanium (Ge), the second element is silicon (Si), the third element is nitrogen (N), the fourth element is oxygen (O), the first material is silicon germanium (SiGe), the second material is silicon (Si), the third material is silicon nitride (SiN), the fourth material is silicon oxide (SiO), and the wafer 200 is single crystal Si. That is, the first material contains the second element in addition to the first element. Further, the third material contains the second element in addition to the third element. Further, the fourth material contains the second element in addition to the fourth element. Further, the wafer 200 contains the first element. That is, in this example, the first surface is constituted by a silicon germanium film (SiGe film) as a germanium-containing film, the second surface is constituted by a silicon film (Si film) as a silicon-containing film, the third surface is constituted by a silicon nitride film ($Si_3N_4$ film, hereinafter also referred to as a SiN film) as a nitrogen-containing film, and the fourth surface is constituted by a silicon oxide film ($SiO_2$ film, hereinafter also referred to as a SiO film) as an oxygen-containing film.

More specifically, a laminated structure formed by alternately laminating the first material (SiGe) and the second material (Si) is formed on the surface of the wafer 200, the third material (SiN) is formed over the laminated structure, and the fourth material (SiO) is formed on the third material. Further, the fourth material (SiO) is formed between the third material (SiN) and the laminated structure of the first material (SiGe) and the second material (Si). That is, the laminated structure formed by alternately laminating the SiGe film and the Si film is formed on the surface of the wafer 200, the SiO film is formed on the laminated structure, the SiN film is formed on the SiO film, and the SiO film is formed on the SiN film. By partially removing a portion, which is constituted by the SiGe film, of the side wall of the laminated structure of the SiGe film and the Si film, a recess whose top surface and side surface are constituted by the second material (Si), whose bottom surface is constituted by the first material (SiGe), and whose depth direction is a direction (horizontal direction) parallel to the surface of the wafer 200 is formed on the side wall of the laminated structure. In the present disclosure, as shown in FIG. 5A, a portion of the recess constituted by the first material (SiGe) is referred to as a bottom surface. With the bottom surface as a reference, a portion of the recess that is constituted by the second material (Si), is in contact with the bottom surface, and is formed perpendicular to the bottom surface is referred to as a side surface, and a portion of the recess that is constituted by the second material (Si), is not in contact with the bottom surface and is formed parallel to the bottom surface is referred to as a top surface.

Further, symbols A, A1, A2, B, C, D, E, and F in FIG. 4 indicate steps A, A1, A2, B, C, D, E, and F, respectively, which are described below, and a symbol P indicates purging performed in steps other than step D.

A processing sequence shown in FIG. 4 includes: step A performing: step A1 of exciting an oxidizing agent and a reducing agent into a plasma state and supplying them to a wafer 200 including a first surface and a second surface; and step A2 of exciting a reducing agent into a plasma state and supplying it to the wafer 200; and step B of heat-treating the wafer 200 subjected to step A. The wafer 200 further includes at least one selected from the group of the third surface and the fourth surface. FIG. 5A shows an example in which the wafer 200 includes the first surface (the surface of the SiGe film), the second surface (the surface of the Si film), the third surface (the surface of the SiN film), and the fourth surface (the surface of the SiO film).

The processing temperature in step B may be equal to or higher than the processing temperature in step A. Further, a processing temperature in step B may be equal to or higher than each of processing temperatures in steps A and C. Further, the processing temperature in step B may be equal to or higher than each of the processing temperatures in steps A, C, and D. The processing sequence shown in FIG. 4 shows an example in which the processing temperature in step B is set to be higher than the processing temperature in step A. Further, the processing sequence shown in FIG. 4 shows an example in which the processing temperature in step B is set to be higher than each of the processing temperatures in steps A and C. Further, the processing sequence shown in FIG. 4 shows an example in which the processing temperature in step B is set to be higher than each of the processing temperatures in steps A, C, and D. In the processing sequence shown in FIG. 4, for example, the processing temperature in step B may be 100 degrees C or higher and 400 degrees C or lower.

In step A, a high-density hydroxyl group termination (hereinafter, also referred to as an OH termination or an OH group) is formed on the first surface and the second surface of the wafer 200, and in step B, the high-density OH termination formed on the first surface is removed while leaving the high-density OH termination formed on the second surface. More specifically, in step A, the high-density OH termination is formed on the first surface, the second surface, and at least one selected from the group of the third surface and the fourth surface of the wafer 200, and in step B, the high-density OH termination formed on the first surface is removed while leaving the high-density OH termination formed on the second surface and the at least one selected from the group of the third surface and the fourth surface. Further, in the embodiments of the present disclosure, in step A, the high-density OH termination is formed on the first surface, the second surface, and the third surface of the wafer 200. Since the fourth surface is constituted by the SiO film, a sufficient amount of OH termination is formed on the fourth surface before step A is performed. However, in a case such as when the OH termination on the fourth surface is insufficient, the OH termination on the fourth surface may be reinforced in step A. Accordingly, in the embodiments of the present disclosure, by performing step A, the high-density OH termination may be formed on each of the first surface, the second surface, the third surface, and the fourth surface (each surface may contains the high-density OH termination), and by performing step B, the high-density OH termination formed on the first surface may be removed while maintaining a state in which the high-density OH termination is formed on each of the second surface, the third surface, and the fourth surface (each surface contains the high-density OH termination).

That is, in step A, the first surface and the second surface are oxidized (plasma-oxidized) to be modified, and in step B, an oxide (oxide film) formed on the first surface is sublimated to be removed while leaving an oxide (oxide film) formed on the second surface. More specifically, in step A, the first surface, the second surface, and at least one selected from the group of the third surface and the fourth surface are oxidized to be modified, and in step B, an oxide formed on the first surface is sublimated to be removed while leaving an oxide formed on the second surface and at least one selected from the group of the third surface and the fourth surface. In the embodiments of the present disclosure, in step A, the first surface, the second surface, and the third surface of the wafer 200 are oxidized to be modified. Since the fourth surface is constituted by the SiO film, the fourth surface is not be oxidized. However, in a case where the fourth surface contains an oxidizable element, the fourth surface may also be oxidized to be modified. Accordingly, in the embodiments of the present disclosure, by performing step A, each of the first surface, the second surface, the third surface, and the fourth surface of the wafer 200 may be oxidized (each surface may contain an oxide), and by performing step B, the oxide formed on the first surface may be sublimated to be removed while maintaining a state in which each of the second surface, the third surface, and the fourth surface is oxidized (each surface contains an oxide). Further, in step A, the oxide formed on the first surface, the second surface, and the third surface of the wafer 200 is constituted by a very thin, uniform, and layer-like or film-like material. Such a very thin, uniform, and layer-like or film-like oxide is also referred to simply as an oxide layer or an oxide film.

By oxidizing and modifying each surface as described above, a high-density OH termination may be formed on each surface. Further, by leaving (maintaining) an oxide on a predetermined surface, the high-density OH termination may be leaved (maintained) on the predetermined surface. Further, by sublimating and removing an oxide on a specific surface, the OH termination on the specific surface may be removed. As a result, the second surface, the third surface, and the fourth surface before performing step C contain the high-density OH termination. On the other hand, the first surface before performing step C does not contain an OH termination, or contains an OH termination of an amount that is much smaller than an amount of OH termination on the second surface, the third surface, and the fourth surface.

The processing sequence shown in FIG. 4 further includes step C of forming an inhibitor layer on the second surface by supplying a modifying agent to the wafer 200 subjected to step B. More specifically, in step C, the inhibitor layer is formed on the second surface and at least one selected from the group of the third surface and the fourth surface. Further, in the embodiments of the present disclosure, as shown in FIG. 5B, an example of forming an inhibitor layer on each of the second surface, the third surface, and the fourth surface is shown. In the embodiments of the present disclosure, a high-density inhibitor layer may be formed on each of the second surface, the third surface, and the fourth surface.

The processing sequence shown in FIG. 4 further includes step D of forming a film on the first surface by supplying a film-forming agent to the wafer 200 subjected to step C. FIG. 5C shows an example in which the recess is filled with a film by selectively growing the film on the first surface among the first surface, the second surface, the third surface, and the fourth surface.

More specifically, as shown in FIG. 4, in step D, a cycle including non-simultaneously performing step D1 of supplying a precursor and a catalyst as a film-forming agent to the wafer 200 and step D2 of supplying a reactant and a catalyst as a film-forming agent to the wafer 200 is performed a predetermined number of times. As a result, the film may be grown starting from the first surface, that is, the bottom surface of the recess, and then grown in a bottom-up manner within the recess to fill the recess.

In the present disclosure, for the sake of convenience, the above-described processing sequence may also be denoted as follows. The same notation is also used in the description of modifications and other embodiments described below. Further, the notations "oxidizing agent*" and "reducing agent*" mean an oxidizing agent and a reducing agent excited into a plasma state, respectively.

$$\text{Oxidizing agent}^* + \text{Reducing agent}^* \rightarrow \text{Reducing agent}^* \rightarrow \text{Heat treatment} \rightarrow \text{Modifying agent} \rightarrow (\text{Precursor} + \text{Catalyst} \rightarrow \text{Reactant} + \text{Catalyst}) \times n$$

At this time, as in the processing sequence shown below, depending on process conditions, the catalyst may not be supplied, or the catalyst may be supplied to the wafer 200 in at least one selected from the group of step D1 and step D2. FIG. 4 shows an example of supplying the catalyst to the wafer 200 in each of step D1 and step D2.

$$\text{Oxidizing agent}^* + \text{Reducing agent}^* \rightarrow \text{Reducing agent}^* \rightarrow \text{Heat treatment} \rightarrow \text{Modifying agent} \rightarrow (\text{Precursor} \rightarrow \text{Reactant}) \times n$$

$$\text{Oxidizing agent}^* + \text{Reducing agent}^* \rightarrow \text{Reducing agent}^* \rightarrow \text{Heat treatment} \rightarrow \text{Modifying agent} \rightarrow (\text{Precursor} + \text{Catalyst} \rightarrow \text{Reactant}) \times n$$

$$\text{Oxidizing agent}^* + \text{Reducing agent}^* \rightarrow \text{Reducing agent}^* \rightarrow \text{Heat treatment} \rightarrow \text{Modifying agent} \rightarrow (\text{Precursor} \rightarrow \text{Reactant} + \text{Catalyst}) \times n$$

$$\text{Oxidizing agent}^* + \text{Reducing agent}^* \rightarrow \text{Reducing agent}^* \rightarrow \text{Heat treatment} \rightarrow \text{Modifying}$$

$$\text{agent} \rightarrow (\text{Precursor} + \text{Catalyst} \rightarrow \text{Reactant} + \text{Catalyst}) \times n$$

Further, the processing sequence shown in FIG. 4 further includes step E of performing post-treatment (PT) on the film formed to fill the recess by heating and heat-treating the wafer 200 after performing step D.

Further, the processing sequence shown in FIG. 4 further includes step F of removing a native oxide film formed on the first surface, the second surface, and at least one selected from the group of the third surface and the fourth surface by supplying an etching agent to the wafer 200 before performing step A. Further, in the embodiments of the present disclosure, in step F, a native oxide film formed on each of the first surface, the second surface, and the third surface may be removed.

In the embodiments of the present disclosure, an example in which the first surface is the surface of the SiGe film, the second surface is the surface of the Si film, the third surface is the surface of the SiN film, the fourth surface is the surface of the SiO film, and in step D, a silicon oxycarbide film (SiOC film), which is a film containing silicon (Si), oxygen (O), and carbon (C), or a silicon oxide film (SiO film), which is a film containing silicon (Si) and oxygen (O), is grown as a film will be described.

When the term "wafer" is used in the present disclosure, it may refer to a wafer itself" or "a stacked body of a wafer and certain layers or films formed on a surface of the wafer." When the phrase "a surface of a wafer" is used in the present disclosure, it may refer to "a surface of a wafer itself" or "a surface of a certain layer formed on a wafer." When the expression "a certain layer is formed on a wafer" is used in the present disclosure, it may mean that "a certain layer is formed directly on a surface of a wafer itself" or that "a certain layer is formed on a layer formed on a wafer." When the term "substrate" is used in the present disclosure, it may be synonymous with the term "wafer."

The term "agent" used in the present disclosure includes at least one selected from the group of a gaseous substance and a liquefied substance. The liquefied substance includes a misty substance. That is, each of the etching agent, the oxidizing agent, the reducing agent, the modifying agent, and the film-forming agent (the precursor, the reactant, and the catalyst) may include a gaseous substance, a liquefied substance such as a misty substance, or both of them.

The term "layer" used in the present disclosure includes at least one selected from the group of a continuous layer and a discontinuous layer. For example, the inhibitor layer may include a continuous layer, a discontinuous layer, or both of them as long as it may cause a film-forming inhibitory action (adsorption inhibitory action or reaction inhibitory action).

(Wafer Charging and Boat Loading)

After the boat 217 is charged with a plurality of wafers 200 (wafer charging), the shutter 219s is moved by the shutter opening/closing equipment 115s and the lower end opening of the manifold 209 is opened (shutter open). Thereafter, as shown in FIG. 1, the boat 217 charged with the plurality of wafers 200 is lifted up by the boat elevator 115 to be loaded into the process chamber 201 (boat loading). In this state, the seal cap 219 seals the lower end of the manifold 209 via the O-ring 220b. Thus, the wafers 200 are placed inside the process chamber 201.

(Pressure Regulation and Temperature Regulation)

After the boat loading is completed, the interior of the process chamber 201, that is, a space where the wafers 200 are placed, is vacuum-exhausted (decompression-exhausted) by the vacuum pump 246 to reach a desired pressure (state of vacuum). At this time, the internal pressure of the process chamber 201 is measured by the pressure sensor 245, and the APC valve 244 is feedback-controlled based on the measured pressure information. Further, the wafers 200 in the process chamber 201 are heated by the heater 207 so as to reach a desired temperature. At this time, a state of supplying electric power to the heater 207 is feedback-controlled based on the temperature information detected by the temperature sensor 263 such that a temperature distribution inside the process chamber 201 becomes a desired temperature distribution. Further, the rotation of the wafers 200 by the rotator 267 is started. The exhaust of the interior of the process chamber 201 and the heating and rotation of the wafers 200 are continuously performed at least until the processing on the wafers 200 is completed.

(Step F: Native Oxide Film Removal)

Thereafter, an etching agent is supplied to the wafer 200.

Specifically, the valve 243e is opened to allow the etching agent (etching gas) to flow through the gas supply pipe 232e. A flow rate of the etching agent is regulated by the MFC 241e, and the etching agent is supplied into the process chamber 201 via the gas supply pipe 232b and the nozzle 249b and is exhausted via the exhaust port 231a. In this operation, the etching agent is supplied to the wafer 200 from the side of the wafer 200 (etching agent supply). At this time, the valves 243f to 243h may be opened to allow an inert gas to be supplied into the process chamber 201 via the nozzles 249a to 249c, respectively.

By supplying the etching agent to the wafer 200 under a process condition described below, a native oxide film formed on the surface of the wafer 200 may be removed. That is, the native oxide film on the first surface and the second surface of the wafer 200 may be removed. Specifically, the native oxide film on the surface of the recess whose top surface and side surface formed on the surface of the wafer 200 are constituted by the Si film, whose bottom surface is constituted by the SiGe film, and whose depth direction is a direction (horizontal direction) parallel to the surface of the wafer 200 may be removed. Further, the native oxide film on the third surface of the wafer 200 may be removed. Specifically, the native oxide film on the third surface constituted by the SiN film, which is the surface of a portion of the wafer 200 other than the recess, may be removed. Further, since the fourth surface of the wafer 200 is constituted by the SiO film, a native oxide film is not formed on the fourth surface, but in a case where a native oxide film is formed on the fourth surface for some reason, the native oxide film may also be removed.

A process condition when the etching agent is supplied in step F is exemplified as follows:

Processing temperature: room temperature (25 degrees C) to 200 degrees C, specifically 50 to 150 degrees C
Processing pressure: 10 to 13,332 Pa, specifically 20 to 1,333 Pa
Processing time: 1 to 120 minutes, specifically 10 to 60 minutes
Supply flow rate of etching agent: 0.05 to 5 slm, specifically 0.5 to 2 slm
Inert gas supply flow rate (for each gas supply pipe): 0 to 20 slm

In the present disclosure, the notation of a numerical range such as "25 to 200 degrees C" means that a lower limit value and an upper limit value thereof are included in the range. Therefore, for example, "25 to 200 degrees C" means "25 degrees C or higher and 200 degrees C or lower." The same applies to other numerical ranges. In the present disclosure, the processing temperature means the temperature of the wafer 200 or the internal temperature of the process chamber 201, and the processing pressure means the internal pressure of the process chamber 201. Further, the gas supply flow rate of 0 slm means a case where no gas is supplied. These apply equally to the following description.

After the native oxide film formed on the surface of the wafer 200 is removed, the valve 243e is closed to stop the supply of the etching agent into the process chamber 201. Then, the interior of the process chamber 201 is vacuum-exhausted to remove a gaseous substance and the like remaining in the process chamber 201 from the process chamber 201. At this time, the valves 243f to 243h are opened to allow an inert gas to be supplied into the process chamber 201 via the nozzles 249a to 249c. The inert gas supplied from the nozzles 249a to 249c acts as a purge gas, whereby the interior of the process chamber 201 is purged (purging).

A process condition when the purging is performed in step F is exemplified as follows:

Processing pressure: 1 to 30 Pa
Processing time: 1 to 120 seconds, specifically 1 to 60 seconds
Supply flow rate of inert gas (for each gas supply pipe): 0.5 to 20 slm

The processing temperature when the purging is performed in this step may be the same as the processing temperature when the etching agent is supplied.

As the etching agent, for example, a fluorine (F)-containing gas may be used. As the F-containing gas, for example, a chlorine trifluoride ($ClF_3$) gas, a chlorine fluoride (ClF) gas, a nitrogen fluoride ($NF_3$) gas, a hydrogen fluoride (HF) gas, a fluorine ($F_2$) gas, or the like may be used. Various cleaning liquids may also be used as the etching agent. For example, DHF cleaning may be performed by using a HF aqueous solution as the etching agent. Further, for example, SC-1 cleaning (APM cleaning) may be performed by using a cleaning liquid containing ammonia water, hydrogen peroxide water, and pure water as the etching agent. Further, for example, SC-2 cleaning (HPM cleaning) may be performed by using a cleaning liquid containing hydrochloric acid, hydrogen peroxide water, and pure water as the etching agent. Further, for example, SPM cleaning may be performed by using a cleaning liquid containing sulfuric acid and hydrogen peroxide water as the etching agent. One or more selected from the group of these gases and liquids may be used as the etching agent.

As the inert gas, a nitrogen ($N_2$) gas or a rare gas such as an argon (Ar) gas, a helium (He) gas, a neon (Ne) gas, or a xenon (Xe) gas can be used. This point also applies to each step described below. One or more selected from the group of these gases may be used as the inert gas.

(Step A: Plasma Treatment)

Thereafter, step A1 of exciting an oxidizing agent and a reducing agent into a plasma state and supplying them to the wafer 200 and step A2 of exciting a reducing agent into a plasma state and supplying it to the wafer 200 are sequentially performed.

[Step A1: First Plasma Treatment]

In step A1, the oxidizing agent and the reducing agent are excited into the plasma state and supplied to the wafer 200.

Specifically, the valves 243e and 243b are opened to allow the oxidizing agent and the reducing agent to flow through the gas supply pipes 232e and 232b, respectively. Flow rates of the oxidizing agent and the reducing agent are regulated by the MFCs 241e and 241b, respectively, mixed in the gas supply pipe 232b, excited into the plasma state by the RPU 300, supplied into the process chamber 201 via the nozzle 249b, and exhausted via the exhaust port 231a. In this operation, the oxidizing agent and the reducing agent excited into the plasma state are supplied to the wafer 200 from the side of the wafer 200 (oxidizing agent*+reducing agent* supply). In this way, it is possible to excite the oxidizing agent and the reducing agent into the plasma state and supply them to the wafer 200, thereby supplying oxygen (O)-containing radicals, hydrogen (H)-containing radicals, and the like to the wafer 200. These radicals may include O radicals, H radicals, and OH radicals. The treatment by using the oxidizing agent and the reducing agent excited into the plasma state may also include at least one selected from the group of plasma oxidation treatment, oxidizing agent plasma treatment (oxygen plasma treatment, etc.), plasma reduction treatment, reducing agent plasma treatment (hydrogen plasma treatment), and plasma oxidation-reduction treatment. In this operation, the valves 243f to 243h may be opened to allow an inert gas to be supplied into the process chamber 201 via the nozzles 249a to 249c, respectively, or the inert gas may not be supplied.

By exciting the oxidizing agent and the reducing agent into the plasma state and supplying them to the wafer 200 under process conditions described below, an OH termination may be formed on the first surface and the second surface of the wafer 200 after the native oxide film is removed. More specifically, the OH termination may be formed on the first surface, the second surface, and at least one selected from the group of the third surface and the fourth surface of the wafer 200 after the native oxide film is removed. In the embodiments of the present disclosure, the OH termination may be formed on the first surface, the second surface, and the third surface of the wafer 200 after the native oxide film is removed. Since the fourth surface is constituted by the SiO film, a sufficient amount of OH termination is formed on the fourth surface before this step is performed. However, in a case such as when the OH termination on the fourth surface is insufficient, the OH termination on the fourth surface may be reinforced in this step. Accordingly, in the embodiments of the present disclosure, by performing this step, the OH termination may be formed on each of the first surface, the second surface, the third surface, and the fourth surface of the wafer 200 after the native oxide film is removed (each surface may contain the OH termination).

That is, by exciting the oxidizing agent and the reducing agent into the plasma state and supplying them to the wafer 200 under process conditions described below, the first surface and the second surface of the wafer 200 after the native oxide film is removed may be oxidized (plasma-oxidized). More specifically, the first surface, the second surface, and at least one selected from the group of the third surface and the fourth surface of the wafer 200 after the native oxide film is removed may be oxidized. In the embodiments of the present disclosure, the first surface, the second surface, and the third surface of the wafer 200 after the native oxide film is removed may be oxidized. Since the fourth surface is constituted by the SiO film, the fourth surface is not be oxidized. However, in a case where the fourth surface contains an oxidizable element, the fourth surface may also be oxidized. Accordingly, in the embodiments of the present disclosure, by performing this step, each of the first surface, the second surface, the third surface, and the fourth surface of the wafer 200 after the native oxide film is removed may be oxidized (each surface may contain an oxide). As a result, an OH termination may be formed on each of the first surface, the second surface, the third surface, and the fourth surface of the wafer 200 after the native oxide film is removed (each surface may contain the OH termination). Further, as described above, the oxide formed on the first surface, the second surface, and the third surface of the wafer 200 are constituted by a very thin, uniform, and layer-like or film-like material.

Further, by performing this step, an oxide film (oxide) such as a silicon oxide film (SiO film), a germanium oxide film (GeO film), or a silicon germanium oxide film (SiGeO film) is formed on the first surface constituted by the SiGe film, and an OH termination is formed on the surface of the oxide film. Further, an oxide film (oxide) such as a SiO film is formed on the second surface constituted by the Si film, and an OH termination is formed on a surface of the oxide film. Further, an oxide film (oxide) such as a SiO film or a silicon oxynitride film (SiON film) is formed on the third surface constituted by the SiN film, and an OH termination is formed on a surface of the oxide film. The fourth surface constituted by the SiO film is maintained in such a state, and the state in which the OH termination is formed on the fourth surface is maintained, or the OH termination on the fourth surface is reinforced.

A process condition when the oxidizing agent and the reducing agent are excited into the plasma state and supplied in step A1 is exemplified as follows:

Processing temperature: room temperature (25 degrees C) to 300 degrees C, specifically room temperature to 200 degrees C
Processing pressure: 1 to 10,000 Pa, specifically 50 to 1,000 Pa
Processing time: 1 to 1,000 seconds, specifically 60 to 500 seconds
Supply flow rate of oxidizing agent: 0.01 to 1 slm, specifically 0.1 to 0.5 slm
Supply flow rate of reducing agent: 0.01 to 1 slm, specifically 0.1 to 0.5 slm
Supply flow rate of inert gas (for each gas supply pipe): 0 to 10 slm
RF power: 1 to 1,000 W, specifically 100 to 5,000 W

In the state where the OH termination is formed on the first surface, the second surface, and the third surface of the wafer 200 and the OH termination is formed on each of the first surface, the second surface, the third surface, and the fourth surface of the wafer 200, the valves 243e and 243b are closed to stop the supply of the oxidizing agent and the reducing agent into the process chamber 201. Then, a gaseous substance and the like remaining in the process chamber 201 are removed from the process chamber 201 (purging) according to the same processing procedure and process conditions as the purging in step F. The processing temperature when the purging is performed may be the same as the processing temperature when the oxidizing agent and the reducing agent are excited into the plasma state and supplied.

As the oxidizing agent, for example, an oxygen (O)-containing gas may be used. Examples of the O-containing gas may include an oxygen ($O_2$) gas, an ozone ($O_3$) gas, water vapor ($H_2O$ gas), a hydrogen peroxide ($H_2O_2$) gas, a nitrous oxide ($N_2O$) gas, a nitric oxide (NO) gas, a nitrogen dioxide ($NO_2$) gas, a carbon monoxide (CO) gas, a carbon dioxide ($CO_2$) gas, and the like. One or more selected from the group of these gases may be used as the oxidizing agent.

As the reducing agent, for example, a hydrogen (H)-containing gas such as hydrogen ($H_2$) gas or a deuterium (D)-containing gas such as a deuterium ($D_2$) gas may be used. One or more selected from the group of these gases may be used as the reducing agent. This point also applies to step A2 described below.

[Step A2: Second Plasma Treatment]

After step A1 is completed, step A2 is performed. In step A2, a reducing agent is excited into a plasma state and supplied to the wafer 200.

Specifically, the valve 243b is opened to allow the reducing agent to flow through the gas supply pipe 232b. A flow rate of the reducing agent is regulated by the MFC 241b, excited into a plasma state by the RPU 300, supplied into the process chamber 201 via the nozzle 249b, and exhausted via the exhaust port 231a. In this operation, the reducing agent excited into the plasma state is supplied to the wafer 200 from the side of the wafer 200 (reducing agent* supply). In this way, it is possible to excite the reducing agent into the plasma state and supply it to the wafer 200, thereby supplying hydrogen (H)-containing radicals to the wafer 200. The H-containing radicals may include H radicals. The treatment in which the reducing agent excited into the plasma state is used may also include at least one selected from the group of plasma reduction treatment and reducing agent plasma treatment (hydrogen plasma treatment). At this time, the valves 243f to 243h may be opened to allow an inert gas to be supplied into the process chamber 201 via the nozzles 249a to 249c, respectively, or the inert gas may not be supplied.

By exciting the reducing agent into the plasma state and supplying it to the wafer 200 under process conditions described below, the first surface and the second surface of the wafer 200 on which the OH termination is formed may be modified by plasma treatment in which the reducing agent* is used. More specifically, the first surface, the second surface, and at least one selected from the group of the third surface and the fourth surface of the wafer 200 on which the OH termination is formed may be modified by plasma treatment in which the reducing agent* is used. In the embodiments of the present disclosure, each of the first surface, the second surface, the third surface, and the fourth surface of the wafer 200 in a state where the OH termination is formed (a state in which the OH termination is contained) may be modified by plasma treatment in which the reducing agent* is used. As a result, impurities such as carbon (C) and nitrogen (N) that may be contained in each surface may be removed, thereby increasing purity of the oxide film (oxide) on each surface and thus improving a state of OH termination. As a result, density of OH termination (Si-OH termination) on each surface may be increased, thereby creating a state in which each surface contains the high-density OH termination. That is, by performing step A1 and step A2, it is possible to create a state in which each of the first surface, the second surface, the third surface, and the fourth surface of the wafer 200 contain the high-density OH termination.

At this time, since an oxide film (oxide) is formed on each surface, each surface is not directly exposed to the plasma-excited reducing agent, that is, H-containing radicals, and thus it is possible to prevent plasma damage to a base (SiGe film, Si film, SiN film, or SiO film) constituting each surface. Further, when performing step A2 before performing step A1, since an oxide film (oxide) is not formed on each surface when step A2 is performed, each surface is directly exposed to the plasma-excited reducing agent, that is, H-containing radicals. As a result, the base (SiGe film, Si film, SiN film, or SiO film) constituting each surface may suffer plasma damage. In particular, the Si film constituting the second surface tends to be more susceptible to plasma damage than the other surfaces, and its shape may change when exposed to H-containing radicals. In contrast, according to the embodiments of the present disclosure, the oxide film (oxide) formed on each surface in step A1 acts as a protective film (block film or barrier film), which makes it possible to prevent the base (SiGe film, Si film, SiN film, or SiO film) constituting each surface from being damaged by plasma.

A process condition when the reducing agent is excited into the plasma state and supplied in step A2 is exemplified as follows:

> Processing temperature: room temperature (25 degrees C) to 300 degrees C, specifically room temperature to 200 degrees C
> Processing pressure: 1 to 10,000 Pa, specifically 50 to 1,000 Pa
> Processing time: 1 to 1,000 seconds, specifically 60 to 500 seconds
> Supply flow rate of reducing agent: 0.01 to 1 slm, specifically 0.1 to 0.5 slm
> Supply flow rate of inert gas (for each gas supply pipe): 0 to 10 slm
> RF power: 1 to 1,000 W, specifically 100 to 5,000 W

After each of the first surface, the second surface, the third surface, and the fourth surface of the wafer 200 in the state of containing the OH termination is modified by plasma treatment in which the reducing agent* is used, the valve 243b is closed to stop the supply of the reducing agent into the process chamber 201. Then, a gaseous substance and the like remaining in the process chamber 201 are removed from the process chamber 201 (purging) according to the same processing procedure and process condition as the purging in step F. The processing temperature when the purging is performed may be the same as the processing temperature when the reducing agent is excited into the plasma state and supplied.

As the reducing agent, for example, the same reducing agents as the various reducing agents exemplified in the aforementioned step A1 may be used.

(Step B: Heat Treatment)

After step A is completed, step B is performed. In step B, heat treatment (annealing) is performed on the wafer 200 subjected to step A. Further, in step B, an output of the heater 207 is regulated such that the temperature of the wafer 200 is equal to or higher than the temperature of the wafer 200 in step A, specifically higher than the temperature of the wafer 200 in step A, and that state is maintained.

Specifically, for example, as shown in FIG. 4, in step B, the temperature of the wafer 200, that is, the processing temperature, is set to be higher than the processing temperature in step A. Further, as shown in FIG. 4, the processing temperature in step B may be set to be higher than each of the processing temperatures in step A and step C. Further, the processing temperature in step B may be set to be higher than each of the processing temperatures in step A, step C, and step D. Furthermore, the processing temperature in step B may be set to be higher than each of the processing temperatures in step A, step C, step D, and step F. Hereinafter, the processing temperature in step B is also simply referred to as heat treatment temperature.

Further, as shown in FIG. 4, step B may be performed in parallel with the purging performed after step A (step A2). That is, in step B, the heat treatment may be performed on the wafer 200 while an inert gas is being supplied into the process chamber 201.

In this case, the valves 243f to 243h are opened to allow the inert gas to flow through the gas supply pipes 232a to 232c, respectively. The flow rate of the inert gas is regulated by the MFCs 241f to 241h, and the inert gas is supplied into the process chamber 201 via the nozzles 249a to 249c and is exhausted via the exhaust port 231a. In this operation, the inert gas is supplied to the wafer 200 from the side of the wafer 200. However, the inert gas may not be supplied into the process chamber 201 in step B after the purging performed after step A (step A2) is sufficiently performed.

By performing the heat treatment on the wafer 200 under the process conditions described below, the OH termination formed on the first surface of the wafer 200 may be removed while leaving the high-density OH termination formed on the second surface of the wafer 200. More specifically, the OH termination formed on the first surface of the wafer 200 may be removed while leaving the high-density OH termination formed on the second surface and at least one selected from the group of the third surface and the fourth surface of the wafer 200. In the embodiments of the present disclosure, the OH termination formed on the first surface of the wafer 200 may be removed while maintaining a state in which the high-density OH termination is formed on each of the second surface, the third surface, and the fourth surface (each surface contains the high-density OH termination) of the wafer 200. In some cases, the OH terminations formed on the first surface of the wafer 200 may not be removed completely, and a small portion thereof may remain.

That is, by performing the heat treatment on the wafer 200 under process conditions described below, the oxide (GeO film or the like) formed on the first surface of the wafer 200 may be sublimated to be removed while leaving the oxide formed on the second surface of the wafer 200. More specifically, the oxide formed on the first surface of the wafer 200 may be sublimated to be removed while leaving the oxide formed on the second surface and at least one selected from the group of the third surface and the fourth surface of the wafer 200. In the embodiments of the present disclosure, the oxide formed on the first surface of the wafer 200 may be sublimated to be removed while maintaining a state in which each of the second surface, the third surface, and the fourth surface of the wafer 200 is oxidized (a state in which each surface contains the oxide). In some cases, the oxides formed on the first surface of the wafer 200 may not be removed completely, and a portion thereof may remain.

The reason why the oxide formed on the first surface among the first surface, the second surface, the third surface, and the fourth surface of the wafer 200 may be selectively sublimated to be removed in this way is that the oxide such as the GeO film formed on the first surface is easier to be sublimated than the oxide formed on the second surface, the third surface, and the fourth surface under process conditions described below. Under the process conditions described below, it is possible to sublimate the oxide such as the GeO film formed on the first surface and prevent the oxide formed on the second surface, the third surface, and the fourth surface from being sublimated. That is, under the process conditions described below, it is also possible to perform the heat treatment under the process conditions that the oxide such as the GeO film formed on the first surface is sublimated and the oxide formed on the second surface, the third surface, and the fourth surface is not sublimated.

The high-density OH termination on the second surface, the third surface, and the fourth surface may be left by leaving (maintaining) the oxide on the second surface, the third surface, and the fourth surface of the wafer 200, and the OH termination on the first surface may be removed by sublimating and removing the oxide on the first surface of the wafer 200. As a result, the second surface, the third surface, and the fourth surface before performing step C contain the high-density OH termination. On the other hand, the first surface before performing step C contains no OH termination or an OH termination of an amount much less than an amount of OH termination in the second surface, the third surface, and the fourth surface. That is, the amount (density or concentration) of OH termination on the second surface, the third surface, and the fourth surface before performing step C may be larger (higher) than the amount (density or concentration) of OH termination on the first surface. Further, the amount (density or concentration) of OH termination on the first surface may be zero.

A process condition when the heat treatment is performed on the wafer 200 in step B is exemplified as follows:

Processing temperature (heat treatment temperature): 100 to 400 degrees C, specifically 100 to 350 degrees C, more specifically 100 to 300 degrees C
Processing pressure: 1 to10,000 Pa, specifically 1 to 2,000 Pa
Processing time: 1 to 180 minutes, specifically 10 to 60 minutes
Supply flow rate of inert gas (for each gas supply pipe): 0 to 20 slm

In a case where the heat treatment temperature is lower than 100 degrees C, the oxide formed on the first surface of the wafer 200 may not be sufficiently sublimated, such that the oxide may not be sufficiently removed. By setting the heat treatment temperature to 100 degrees C or higher, the oxide formed on the first surface of the wafer 200 may be sufficiently sublimated to be sufficiently removed.

In a case where the heat treatment temperature exceeds 400 degrees C, at least a portion of the OH termination on the second surface, the third surface, and the fourth surface of the wafer 200 may be desorbed to be removed, such that the density of the OH termination on these surfaces may be reduced. In this case, in step C, the film formation inhibiting effect (adsorption inhibiting effect or reaction inhibiting effect) by an inhibitor layer formed on the second surface, the third surface, and the fourth surface of the wafer 200 is reduced, such that selectivity in selective growth in step D may be reduced. By setting the heat treatment temperature to 400 degrees C or lower, it is possible to sufficiently suppress desorption and removal of the OH termination on the second surface, the third surface, and the fourth surface of the wafer 200, thereby sufficiently suppressing the density reduction of the OH termination on these surfaces. In this case, in step C, the film formation inhibiting effect by the inhibitor layer formed on the second surface, the third surface, and the fourth surface of the wafer 200 may be sufficiently obtained, such that selectivity in selective growth in step D may be sufficiently secured. By setting the heat treatment temperature to 350 degrees C or lower, it is possible to effectively suppress the desorption and removal of the OH termination on the second surface, the third surface, and the fourth surface of the wafer 200, thereby effectively suppressing the density reduction of the OH termination on these surfaces. By setting the heat treatment temperature to 300 degrees C or less, it is possible to more effectively suppress the desorption and removal of the OH termination on the second surface, the third surface, and the fourth surface of the wafer 200, thereby more effectively suppressing the density reduction of the OH termination on these surfaces.

From these things, in step B, it is desirable that the heat treatment temperature is set to 100 degrees C or higher and 400 degrees C or lower, specifically 100 degrees C or higher and 350 degrees C or lower, more specifically 100 degrees C or higher and 300 degrees C or lower.

After removing the OH termination formed on the first surface of the wafer 200 while maintaining the state in which each of the second surface, the third surface, and the fourth surface of the wafer 200 contains the OH termination, a gaseous substance and the like remaining in the process chamber 201 are removed from the process chamber 201 (purging) according to the same processing procedure and process condition as the purging in step F. The processing temperature when the purging is performed may be the same as the processing temperature when the heat treatment is performed on the wafer 200, but may be different from the processing temperature when the heat treatment is performed on the wafer 200.

(Step C: Inhibitor Layer Formation)

After step B is completed, step C is performed. In step C, a modifying agent is supplied to the wafer 200 subjected to step B.

Specifically, the valve 243a is opened to allow the modifying agent to flow through the gas supply pipe 232a. A flow rate of the modifying agent is regulated by the MFC 241a, and the modifying agent is supplied into the process chamber 201 via the nozzle 249a and is exhausted via the exhaust port 231a. In this operation, the modifying agent is supplied to the wafer 200 from the side of the wafer 200 (modifying agent supply). At this time, the valves 243f to 243h may be opened to allow an inert gas to be supplied into the process chamber 201 via the nozzles 249a to 249c, respectively. Further, in step C, the output of the heater 207 is regulated such that the temperature of the wafer 200 is equal to or lower than the temperature of the wafer 200 in step B, specifically lower than the temperature of the wafer 200 in step B, and that state is maintained.

By supplying the modifying agent to the wafer 200 under process conditions described below, as shown in FIG. 5B, at least a portion of the molecular structure of molecules constituting the modifying agent may be selectively (preferentially) adsorbed on the second surface, the third surface, and the fourth surface at a high density among the first surface, the second surface, the third surface, and the fourth surface of the wafer 200, thereby selectively (preferentially) forming a high-density inhibitor layer on the second surface, the third surface, and the fourth surface. Specifically, by causing a high-density OH group terminating the second surface, the third surface, and the fourth surface to react with the modifying agent while suppressing adsorption of at least a portion of the molecular structure of the molecules constituting the modifying agent on the first surface, it is possible to cause at least a portion of the molecular structure of the molecules constituting the modifying agent to be selectively adsorbed at a high density on the second surface, the third surface, and the fourth surface. This makes it possible to terminate the second surface, the third surface, and the fourth surface at a high density with at least the portion of the molecular structure of the molecules constituting the modifying agent. In this manner, the second surface, the third surface, and the fourth surface may be modified.

The inhibitor layer formed in this step contains at least a portion of the molecular structure of the molecules constituting the modifying agent, which are residues derived from the modifying agent. The inhibitor layer prevents adsorption of a precursor (film-forming agent) on the second surface, the third surface, and the fourth surface to inhibit (suppress) progress of the film-forming reaction on the second surface, the third surface, and the fourth surface in step D described below.

As at least the portion of the molecular structure of the molecules constituting the modifying agent, for example, a trialkylsilyl group such as a trimethylsilyl group (Si-Me$_3$) or a triethylsilyl group (Si-Et$_3$) may be exemplified. The trialkylsilyl group contains an alkyl group, that is, a hydrocarbon group. In these cases, Si of the trimethylsilyl group or the triethylsilyl group is chemisorbed on the second surface, the third surface, and the fourth surface of the wafer 200 at a high density, such that the outermost surface of the second surface, the third surface, and the fourth surface is terminated with an alkyl group such as a methyl group or an ethyl group, that is, with a hydrocarbon group, at a high density. The alkyl group (alkylsilyl group) such as the methyl group (trimethylsilyl group) or the ethyl group (triethylsilyl group), that is, the hydrocarbon group, which terminates the second surface, the third surface, and the fourth surface at the high density, prevents adsorption of a precursor on the second surface, the third surface, and the fourth surface in a film-forming process (selective growth) described below, thereby acting as an inhibitor layer (film formation inhibition layer, adsorption inhibition layer, or reaction inhibition layer) that inhibits the progress of the film formation reaction on the second surface, the third surface, and the fourth surface.

Further, in this step, at least the portion of the molecular structure of the molecules constituting the modifying agent may be adsorbed on a portion of the first surface of the wafer 200 but an adsorption amount thereof is very small, and an adsorption amount thereof on the second surface, the third surface, and the fourth surface of the wafer 200 is overwhelmingly large. Such selective (preferential) adsorption is possible because the process condition in this step is a condition that the modifying agent does not undergo gas phase decomposition in the process chamber 201. This is also possible because the second surface, the third surface, and the fourth surface are OH-terminated at the high density over the entire region, whereas many regions on the first surface are not OH-terminated. In this step, since the modifying agent does not undergo the gas phase decomposition in the process chamber 201, at least a portion of the molecular structure of the molecules constituting the modifying agent is not multiple-deposited on the first surface, the second surface, the third surface, and the fourth surface, and at least a portion of the molecular structure of the molecules constituting the modifying agent is selectively adsorbed on the second surface, the third surface, and the fourth surface at a high density, whereby the second surface, the third surface, and the fourth surface are selectively terminated at a high density with at least the portion of the molecular structure of the molecules constituting the modifying agent.

A process condition when the modifying agent is supplied in step C is exemplified as follows:

Processing temperature: room temperature (25 degrees C) to 500 degrees C, specifically room temperature to 250 degrees C
Processing pressure: 5 to 2,000 Pa, specifically 10 to 1,000 Pa
Processing time: 1 second to 120 minutes, specifically 30 seconds to 60 minutes
Supply flow rate of modifying agent: 0.001 to 3 slm, specifically 0.001 to 0.5 slm
Supply flow rate of inert gas (for each gas supply pipe): 0 to 20 slm

After selectively forming the inhibitor layer on the second surface, the third surface, and the fourth surface of the wafer 200 at a high density, the valve 243a is closed to stop the supply of the modifying agent into the process chamber 201. Then, a gaseous substance and the like remaining in the process chamber 201 are removed from the process chamber 201 (purging) according to the same processing procedure and process condition as in the purging in step F. The processing temperature when the purging is performed may be the same as the processing temperature when the modifying agent is supplied.

As the modifying agent, for example, a compound containing a structure in which an amino group is directly bonded to Si or a compound containing a structure in which an amino group and an alkyl group are directly bonded to Si may be used.

Examples of the modifying agent may include (dimethylamino)silane ((CH3)$_2$NSiH$_3$), (diethylamino)silane ((C$_2$H$_5$)$_2$NSiH$_3$), (dipropylamino)silane ((C$_3$H$_7$)$_2$NSiH$_3$), (dibutylamino)silane ((C$_4$H$_9$)$_2$NSiH$_3$), (dimethylamino)trimethyl-silane ((CH$_3$)$_2$NSi(CH$_3$)$_3$), (diethylamino)triethylsilane ((C$_2$H$_5$)$_2$NSi(C$_2$H$_5$)$_3$), (dimethylamino)triethylsilane ((CH$_3$)$_2$NSi(C$_2$H$_5$)$_3$), (diethylamino)trimethylsilane ((C$_2$H$_5$)$_2$NSi(CH$_3$)$_3$), (dipropylamino)trimethylsilane ((C$_3$H$_7$)$_2$NSi(CH$_3$)$_3$), (dibutylamino)trimethylsilane ((C$_4$H$_9$)$_2$NSi(CH$_3$)$_3$), (trimethylsilyl)amine ((CH$_3$)$_3$SiNH$_2$), (triethylsi-lyl)amine ((C$_2$H$_5$)$_3$SiNH$_2$), and the like. Further, examples of the modifying agent may include bis(dimethylamino)dimeth-ylsilane ([(CH$_3$)$_2$N]$_2$Si(CH$_3$)$_2$), bis(diethylamino)diethylsilane ([(C$_2$H$_5$)$_2$N]$_2$Si(C$_2$H$_5$)$_2$), bis(dimethylamino)diethylsilane ([(CH$_3$)$_2$N]$_2$Si(C$_2$H$_5$)$_2$), bis(diethylamino)dimethylsilane ([(C$_2$H$_5$)$_2$N]$_2$Si(CH$_3$)$_2$), bis(dimethylamino)silane ([(CH$_3$)$_2$N]$_2$SiH$_2$), bis(diethylamino)silane ([(C$_2$H$_5$)$_2$N]$_2$SiH$_2$), bis(dimethylaminodimethylsilyl)ethane ([(CH$_3$)$_2$N(CH$_3$)$_2$Si]$_2$C$_2$H$_6$), bis(dipropylamino)silane ([(C$_3$H$_7$)$_2$N]$_2$SiH$_2$), bis(dibutylamino)silane ([(C$_4$H$_9$)$_2$N]$_2$SiH$_2$), bis(dipropylamino)dimethylsilane ([(C$_3$H$_7$)$_2$N]$_2$Si(CH$_3$)$_2$), bis(dipropylamino)diethylsilane ([(C$_3$H$_7$)$_2$N]$_2$Si(C$_2$H$_5$)$_2$), (dimethylsilyl)diamine ((CH$_3$)$_2$Si(NH$_2$)$_2$), (diethylsilyl)diamine ((C$_2$H$_5$)$_2$Si(NH$_2$)$_2$), (dipropylsilyl)diamine ((C$_3$H$_7$)$_2$Si(NH$_2$)$_2$), bis(dimethylaminodimethylsilyl)methane ([(CH$_3$)$_2$N(CH$_3$)$_2$Si]$_2$CH$_2$), bis(dimethylamino)tetramethyld-isilane ([(CH$_3$)$_2$N]$_2$(CH$_3$)$_4$Si$_2$), and the like. One or more selected from the group of these may be used as the modifying agent.

(Step D: Film-Forming Process (Selective Growth))

After step C is completed, step D is performed. In step D, a film-forming agent is supplied to the wafer 200 subjected to step C. Further, in step D, the output of the heater 207 is regulated such that the temperature of the wafer 200 is equal to or lower than the temperature of the wafer 200 in step C, and while maintaining such a state, steps D1 and D2 are sequentially executed.

[Step D1: First Layer Formation]

In step D1, a precursor (precursor gas) and a catalyst (catalyst gas) are supplied as a film-forming agent to the wafer 200 subjected to step C, that is, the wafer 200 after selectively forming the high-density inhibitor layer on the second surface, the third surface, and the fourth surface.

Specifically, the valves 243b and 243d are opened to allow the precursor and the catalyst to flow through the gas supply pipes 232b and 232d, respectively. Flow rates of the precursor and the catalyst are regulated by the MFCs 241b and 241d, respectively, and the precursor and the catalyst are supplied into the process chamber 201 via the nozzles 249b and 249a, respectively, mixed in the process chamber 201, and exhausted via the exhaust port 231a. In this operation, the precursor and the catalyst are supplied to the wafer 200 from the side of the wafer 200 (precursor+catalyst supply). In this operation, the valves 243f to 243h may be opened to allow an inert gas to be supplied into the process chamber 201 via the nozzles 249a to 249c, respectively.

By supplying the precursor and the catalyst to the wafer 200 under process conditions described below, it is possible to selectively (preferentially) chemisorb at least a portion of the molecular structure of molecules constituting the precursor on the first surface of the wafer 200 while suppressing chemisorption of at least the portion of the molecular structure of the molecules constituting the precursor on the second surface, the third surface, and the fourth surface of the wafer 200. As a result, a first layer is selectively (preferentially) formed on the first surface. The first layer contains at least a portion of the molecular structure of the molecules constituting the precursor, which are residues derived from the precursor. That is, the first layer contains at least a portion of atoms constituting the precursor.

In this step, by supplying the catalyst together with the precursor, the above-described reaction may be allowed to proceed under a non-plasma atmosphere and under a low temperature condition described below. In this way, by forming the first layer under the non-plasma atmosphere and under the low temperature condition as described below, it is possible to suppress removal and/or invalidation of the inhibitor layer formed on the second surface, the third surface, and the fourth surface of the wafer 200. The invalidation of the inhibitor layer means that the molecular structure of the molecules constituting the inhibitor layer, the arrangement structure of atoms constituting the inhibitor layer, etc. are changed to enable the adsorption of the film-forming agent on the second surface, the third surface, and the fourth surface of the wafer 200 or the reaction between the second surface/third surface/fourth surface and the film-forming agent.

Further, by forming the first layer under the non-plasma atmosphere and under the low temperature condition as described below, the precursor may be prevented from being thermally decomposed (gas phase-decomposed), that is, autolyzed, in the process chamber 201. As a result, it is possible to prevent multiple deposition of at least a portion of the molecular structure of molecules constituting the precursor on the first surface, the second surface, the third surface, and the fourth surface of the wafer 200 and cause the precursor to be selectively adsorbed on the first surface among the first surface, the second surface, the third surface, and the fourth surface of the wafer 200.

A process condition when the precursor and the catalyst are supplied in step D1 is exemplified as follows:

Processing temperature: room temperature (25 degrees C) to 200 degrees C, specifically room temperature to 150 degrees C
Processing pressure: 133 to 1,333 Pa
Processing time: 1 to 120 seconds, specifically 1 to 60 seconds
Supply flow rate of precursor: 0.001 to 2 slm
Supply flow rate of catalyst: 0.001 to 2 slm
Supply flow rate of inert gas (for each gas supply pipe): 0 to 20 slm

After selectively forming the first layer on the first surface of the wafer 200, the valves 243b and 243d are closed to stop the supply of the precursor and the catalyst, respectively, into the process chamber 201. Then, a gaseous substance and the like remaining in the process chamber 201 are removed from the process chamber 201 (purging) according to the same processing procedure and process condition as the purging in step F. The processing temperature when the purging is performed may be the same as the processing temperature when the precursor and the catalyst are supplied.

Further, in this step, when forming the first layer, at least a portion of the molecular structure of the molecules constituting the precursor may be adsorbed on portions of the second surface, the third surface, and the fourth surface of the wafer 200, but an adsorption amount thereof is very small and an adsorption amount thereof on the first surface of the wafer 200 is overwhelmingly large. Such selective (preferential) adsorption is possible because the process condition in this step is the low temperature condition and the condition that the precursor does not undergo vapor phase decomposition in the process chamber 201 as described above. Further, this is also possible because the high-density inhibitor layer is formed over the entire region of the second surface, the third surface, and the fourth surface of the wafer 200, whereas the inhibitor layer is not formed in many regions of the first surface of the wafer 200.

As the precursor, for example, a halosilane-based gas, that is, a Si- and halogen-containing gas (Si- and halogen-containing substance), may be used. The halogen includes chlorine (Cl), fluorine (F), bromine (Br), iodine (I), and the like. The Si- and halogen-containing gas may contain halogen in the form of a chemical bond between Si and halogen. As the Si- and halogen-containing gas, for example, a silane-based gas containing a Si-Cl bond, that is, a chlorosilane-based gas, may be used. The Si- and halogen-containing gas may further contain C, and in such a case, C may be contained in the form of a Si-C bond. As the Si- and halogen-containing gas, for example, a silane-based gas containing Si, Cl, and an alkylene group and containing a Si-C bond, that is, an alkylenechlorosilane-based gas, may be used. The alkylene group includes a methylene group, an ethylene group, a propylene group, a butylene group, and the like. Further, as the Si- and halogen-containing gas, for example, a silane-based gas containing Si, Cl, and an alkyl group and containing a Si-C bond, that is, an alkylchlorosilane-based gas, may be used. The alkyl group includes a methyl group, an ethyl group, a propyl group, a butyl group, and the like. The Si- and halogen-containing gas may further contain O, and in such a case, O may be contained in the form of a Si-O bond, for example in the form of a siloxane bond (Si-O-Si bond). As the Si- and halogen-containing gas, for example, a silane-based gas containing Si, Cl, and a siloxane bond, that is, a chlorosiloxane-based gas, may be used. These gases may contain Cl in the form of a Si-Cl bond. As the precursor, in addition to these gases, an amino group-containing gas (amino group-containing substance) such as an aminosilane-based gas may also be used.

Examples of the precursor may include 1,1,3,3-tetrachloro-1,3-disilacyclobutane ($C_2H_4Cl_4Si_2$), 1,1,2,2-tetrachloro-1,2-dimethyldisilane (($CH_3$)$_2Si_2Cl_4$), 1,2-dichloro-1,1,2,2-tetramethyldisilane (($CH_3$)$_4Si_2Cl_2$), bis(trichlorosilyl)methane (($SiCl_3$)$_2CH_2$), 1,2-bis(trichlorosilyl)ethane (($SiCl_3$)$_2C_2H_4$), and the like. Further, examples of the precursor may include tetrachlorosilane ($SiCl_4$), hexachlorodisilane ($Si_2Cl_6$), octachlorotrisilane ($Si_3Cl_8$), and the like. Further, examples of the precursor may include hexachlorodisiloxane ($Cl_3Si$-O-$SiCl_3$), octachlorotrisiloxane ($Cl_3Si$-O-$SiCl_2$-O-$SiCl_3$), and the like. Further, examples of the precursor may include tetrakis(dimethylamino)silane ($Si[N(CH_3)_2]_4$), tris(dimethylamino)silane ($Si[N(CH_3)_2]_3H$), bis(diethylamino)silane ($Si[N(C_2H_5)_2]_2H_2$), bis(tert-butylamino)silane ($SiH_2[NH(C_4H_9)]_2$), (diisopropylamino)silane ($SiH_3[N(C_3H_7)_2]$), and the like. One or more selected from the group of these gases may be used as the precursor.

As the catalyst, for example, an amine-based gas (amine-based substance) containing carbon (C), nitrogen (N), and hydrogen (H) may be used. As the amine-based gas (amine-based substance), a chain amine-based gas (chain amine-based substance) or a cyclic amine-based gas (cyclic amine-based substance) may be used. Examples of the catalyst may include chain amines such as triethylamine (($C_2H_5$)$_3N$), diethylamine (($C_2H_5$)$_2NH$), monoethylamine (($C_2H_5$)$NH_2$), trimethylamine (($CH_3$)$_3N$), dimethylamine (($CH_3$)$_2NH$), and monomethylamine (($CH_3$)$NH_2$). Further, examples of the catalyst may include cyclic amines such as aminopyridine ($C_5H_6N_2$), pyridine ($C_5H_5N$), picoline ($C_6H_7N$), lutidine ($C_7H_9N$), pyrimidine ($C_4H_4N_2$), quinoline ($C_9H_7N$), piperazine ($C_4H_{10}N_2$), piperidine ($C_5H_{11}N$), and aniline ($C_6H_7N$). One or more selected from the group of these may be used as the catalyst. This point also applies to a reactant supplying step described below.

[Step D2: Second Layer Formation]

In step D2, a reactant (reactant gas) and a catalyst (catalyst gas) are supplied as a film-forming agent to the wafer 200 subjected to step D1, that is, the wafer 200 with the first layer selectively formed on the first surface. Herein, an example in which an oxidizing agent (oxidizing gas) is used as a reactant (reacting gas) will be described.

Specifically, the valves 243c and 243d are opened to allow the reactant and the catalyst to flow through the gas supply pipes 232c and 232d, respectively. Flow rates of the reactant and the catalyst are regulated by the MFCs 241c and 241d, respectively, and the reactant and the catalyst are supplied into the process chamber 201 via the nozzles 249c and 249a, respectively, mixed in the process chamber 201, and exhausted via the exhaust port 231a. In this operation, the reactant and the catalyst are supplied to the wafer 200 from the side of the wafer 200 (reactant+catalyst supply). In this operation, the valves 243f to 243h may be opened to allow an inert gas to be supplied into the process chamber 201 via the nozzles 249a to 249c, respectively.

By supplying the reactant and the catalyst to the wafer 200 under process conditions described below, it is possible to oxidize at least a portion of the first layer formed on the first surface of the wafer 200 in step D 1. As a result, a second layer formed by oxidizing the first layer is formed on the first surface.

In this step, by supplying the catalyst together with the reactant, the above-described reaction may proceed under a non-plasma atmosphere and under a low temperature condition as described below. In this way, by forming the second layer on the first surface under the non-plasma atmosphere and under the low temperature condition as described below, it is possible to suppress removal and/or invalidation of the inhibitor layer formed on the second surface, the third surface, and the fourth surface of the wafer 200.

A process condition when the reactant and the catalyst are supplied in step D2 is exemplified as follows:

Processing temperature: room temperature (25 degrees C) to 200 degrees C, specifically room temperature to 150 degrees C
Processing pressure: 133 to 1,333 Pa
Processing time: 1 to 120 seconds, specifically 1 to 60 seconds
Supply flow rate of reactant: 0.001 to 2 slm
Supply flow rate of catalyst: 0.001 to 2 slm
Supply flow rate of inert gas (for each gas supply pipe): 0 to 20 slm

After oxidizing the first layer formed on the first surface of the wafer 200 to change (convert) the first layer into the second layer, the valves 243c and 243d are closed to stop the supply of the reactant and the catalyst, respectively, into the process chamber 201. Then, a gaseous substance and the like remaining in the process chamber 201 are removed from the process chamber 201 (purging) according to the same processing procedure and process condition as the purging in step F. The processing temperature when the purging is performed may be the same as the processing temperature when the reactant and the catalyst are supplied.

As the reactant, for example, the same oxidizing agent as the various oxidizing agents exemplified in the above-described step A1 may be used. As the catalyst, for example, the same catalyst as the various catalysts exemplified in the above-described step D1 may be used.

[Performing Predetermined Number of Times]

By performing a cycle a predetermined number of times (n times, where n is 1 or an integer of 2 or more), the cycle including non-simultaneously, that is, alternatively without synchronization, performing the above-described steps D1 and D2, a film may be selectively (preferentially) grown on the first surface among the first surface, the second surface, the third surface, and the fourth surface of the wafer 200, to fill the recess with the film, as shown in FIG. 5C. That is, it is possible to grow a film starting from the bottom surface of the recess, which is the first surface of the wafer 200 and grow the film in a bottom-up manner within the recess to fill the recess with the film. For example, when the above-described precursor, reactant, and catalyst are used, a SiOC film or a SiO film may be selectively grown as a film on the first surface to fill the recess with the SiOC film or the SiO film. The above-described cycle may be performed a plurality of times. That is, a thickness of the second layer formed per cycle may be set to be smaller than a desired film thickness, and the above-described cycle may be performed a plurality of times until a thickness of the film formed by stacking second layers reaches the desired film thickness.

Further, by performing the above-described cycle a predetermined number of times, the film may be grown toward an opening side of the recess, starting from the bottom surface (the first surface) of the recess on the surface of the wafer 200. At this time, since the high-density inhibitor layer is formed on the second surface constituting the top surface and the side surface of the recess, it is possible to suppress the growth of the film starting from the second surface. Further, since the high-density inhibitor layer is also formed on the third surface and the fourth surface, which are the surfaces of portions of the surface of the wafer 200 other than the recess, it is also possible to suppress the growth of the film starting from the third surface and the fourth surface. That is, by performing the above-described cycle the predetermined number of times, it is possible to promote the growth of the film starting from the bottom surface of the recess, while suppressing the growth of the film starting from the top surface and the side surface of the recess and the surfaces of portions other than the recess. As a result, it is possible to grow the film in the bottom-up manner within the recess to fill the recess with the film, as shown in FIG. 5C.

Further, when performing steps D1 and D2, as shown in FIG. 5C, since the inhibitor layer formed on the second surface, the third surface, and the fourth surface of the wafer 200 is maintained on the second surface, the third surface, and the fourth surface, as described above, it is possible to suppress the growth of the film starting from the second surface, the third surface, and the fourth surface. However, for example, in a case where the formation of the inhibitor layer on the second surface, the third surface, and the fourth surface is insufficient for some reason, the growth of a film starting from the second surface, the third surface, and the fourth surface may occur very slightly. However, even in this case, a thickness of the film formed starting from the second surface, the third surface, and the fourth surface is much thinner than a thickness of the film formed starting from the first surface. Therefore, even in such a case, the recess may be appropriately filled by the above-described bottom-up growth.

(Step E: PT)

After step D is completed, step E is performed. In step E, the wafer 200 is subjected to heat treatment (annealing) to perform post-treatment (PT) on the film formed to fill the recess. In this operation, the output of the heater 207 is regulated such that the internal temperature of the process chamber 201, that is, the temperature of the wafer 200 with the film formed to fill the recess, is equal to or higher than the temperature of the wafer 200 in steps A, B, C, and D, specifically higher than the temperature of the wafer 200 in these steps.

By performing the PT on the wafer 200, it is possible to remove/repair impurities/defects contained in the film formed to fill the recess, thereby hardening the film. By hardening the film, it is possible to improve a processing resistance of the film, that is, an etching resistance.

Further, by performing the PT on the wafer 200, as shown in FIG. 5D, it is possible to remove and/or invalidate an inhibitor layer on the second surface, the third surface, and the fourth surface of the wafer 200, that is, an interface between the side surface of the recess and the film (SiOC), the other side surface of the recess, the top surface of the recess, and the surfaces of portions other than the recess.

Further, this step may be performed in a state where an inert gas is supplied into the process chamber 201, or may be performed in a state where a reactive substance such as an oxidizing agent (oxidizing gas) is supplied into the process chamber 201. When a reactive substance such as an oxidizing agent is supplied, it is possible to effectively remove/repair impurities/defects contained in the film formed to fill the recess, and harden the film. Further, it is possible to enhance an effect of removing and/or invalidating the inhibitor layer on the interface between the side surface of the recess and the film, the other side surface of the recess, the top surface of the recess, and the surfaces of portions other than the recess. In this case, the inert gas and the reactive substance such as the oxidizing agent (oxidizing gas) are also referred to as an assistant substance. At this time, the assistant substance may be supplied after being excited into a plasma state, which makes it possible to further enhance the above-described effect.

A process condition when PT is performed in step E is exemplified as follows:

Processing temperature: 200 to 1,000 degrees C, specifically 400 to 700 degrees C
Processing pressure: 1 to 120,000 Pa
Processing time: 1 to 18,000 seconds
Supply flow rate of assistant substance: 0 to 50 slm
RF power: 0 to 10,000 W

For the film formed to fill the recess, in a case where the removal of impurities, the repair of defects, or the hardening of the film may not be performed or in a case where the removal and/or the invalidation of the inhibitor layer may not be performed, step E may be omitted.

(After-Purge and Returning to Atmospheric Pressure)

After step E is completed (after step D is completed in a case where step E is omitted), an inert gas acting as a purge gas is supplied into the process chamber 201 from each of the nozzles 249a to 249c and is exhausted via the exhaust port 231a. Thus, the interior of the process chamber 201 is purged and a gas, reaction by-products, and the like remaining in the process chamber 201 are removed from the process chamber 201 (after-purge). Thereafter, the internal atmosphere of the process chamber 201 is substituted with the inert gas (inert gas substitution) and the internal pressure of the process chamber 201 is returned to the atmospheric pressure (returning to atmospheric pressure).

(Boat Unloading and Wafer Discharging)

Thereafter, the seal cap 219 is moved down by the boat elevator 115 to open the lower end of the manifold 209. Then, the processed wafers 200 supported by the boat 217 are unloaded from the lower end of the manifold 209 to the outside of the reaction tube 203 (boat unloading). After the boat unloading, the shutter 219s is moved and the lower end opening of the manifold 209 is sealed by the shutter 219s via the O-ring 220c (shutter closing). The processed wafers 200 are unloaded from the reaction tube 203 and are then discharged from the boat 217 (wafer discharging).

(3) Effects of the Embodiments of the present disclosure

According to the embodiments of the present disclosure, one or more effects set forth below may be achieved.

(a) By performing: step A performing: step A1 of exciting an oxidizing agent and a reducing agent into a plasma state and supplying them to the wafer 200; and step A2 of exciting a reducing agent into a plasma state and supplying it to the wafer 200; and step B of heat-treating the wafer 200 subjected to step A, the second surface of the wafer 200 may contain a high-density OH termination, and the first surface of the wafer 200 does not contain an OH termination or may contain an OH termination of an amount that is much smaller than an amount of OH termination on the second surface of the wafer 200. That is, the amount (density or concentration) of OH termination on the second surface of the wafer 200 may be larger (higher) than the amount (density or concentration) of OH termination on the first surface of the wafer 200. Further, the amount (density or concentration) of OH termination on the first surface of the wafer 200 may be zero. As a result, in step C, it is possible to cause at least a portion of the molecular structure of molecules constituting a modifying agent to be selectively (preferentially) adsorbed at a high density on the second surface of the wafer 200, thereby selectively (preferentially) forming a high-density inhibitor layer on the second surface. Further, in step D, it is possible to selectively (preferentially) grow a film on the first surface of the wafer 200 with high precision while suppressing the growth of the film on the second surface of the wafer 200. As a result, it is possible to fill the recess with the film with high selectivity while suppressing the growth of the film on the second surface of the wafer 200.

(b) By performing: step A performing: step A1 of exciting an oxidizing agent and a reducing agent into a plasma state and supplying them to the wafer 200; and step A2 of exciting a reducing agent into a plasma state and supplying it to the wafer 200; and step B of heat-treating the wafer 200 subjected to step A, each of the second surface and other surfaces (the third surface and the fourth surface) of the wafer 200 may contain a high-density OH termination, and the first surface of the wafer 200 does not contain an OH termination or may contain an OH termination of an amount that is much smaller than an amount of OH termination on each of the second surface and other surfaces (the third surface and the fourth surface). That is, the amount (density or concentration) of OH termination on each of the second surface and other surfaces (the third surface and the fourth surface) of the wafer 200 may be larger (higher) than the amount (density or concentration) of OH termination on the first surface of the wafer 200. Further, the amount (density or concentration) of OH termination on the first surface of the wafer 200 may be zero. As a result, in step C, it is possible to cause at least a portion of the molecular structure of molecules constituting a modifying agent to be selectively (preferentially) adsorbed at a high density on the second surface and other surfaces (the third surface and the fourth surface) of the wafer 200, thereby selectively (preferentially) forming a high-density inhibitor layer on the second surface and other surfaces (the third surface and the fourth surface). Further, in step D, it is possible to selectively (preferentially) grow a film on the first surface of the wafer 200 with high precision while suppressing the growth of the film on the second surface and other surfaces (the third surface and the fourth surface) of the wafer 200. As a result, it is possible to fill the recess with the film with high selectivity while suppressing the growth of the film on the second surface and other surfaces (the third surface and the fourth surface) of the wafer 200.

(c) By selectively forming a high-density inhibitor layer on the second surface constituting the top surface and the side surface of the recess of the wafer 200, it is possible to promote the growth of a film starting from the bottom surface of the recess while suppressing the growth of the film starting from the top surface and the side surface of the recess. As a result, the film may be grown from the bottom surface side of the recess toward the opening side of the recess, such that the film may be grown in the bottom-up manner within the recess. As a result, it is possible to fill the recess with the film without forming voids or seams in the film. That is, it is possible to form a void-free and seamless film in the recess, thereby improving an embedding characteristic.

(d) By selectively forming a high-density inhibitor layer on the second surface constituting the top surface and the side surface of the recess of the wafer 200 and other surfaces (the third surface and the fourth surface), it is possible to promote growth of a film starting from the bottom surface of the recess while suppressing the growth of the film starting from the top surface and the side surface of the recess and other surfaces (the third surface and the fourth surface). As a result, it is possible to fill the recess with the film without growing the film on the top surface (the second surface) of the recess and other surfaces (the third surface and the fourth surface). As a result, as shown in FIG. 5C, when the film-forming process is completed, it is possible to create a state in which no film (SiOC) is formed on the top surface of the recess and other surfaces (the third surface and the fourth surface). Further, as shown in FIG. 5C, when the film-forming process is completed, it is possible to fill the recess with the film (SiOC) in the side wall of the laminated structure in which the first material (SiGe) and the second material (Si) are alternately laminated on the surface of the wafer 200, such that the side wall may be made flat. As a result, it is possible to omit a step of removing, by etching, an extra film formed on the top surface (the second surface) of the recess and other surfaces (the third surface and the fourth surface) after the film-forming process, which is performed in the related art.

Further, as described above, although the inhibitor layer is formed on the second surface, the third surface, and the fourth surface, the growth of a film starting from the second surface, the third surface, and the fourth surface may occur very slightly for some reason. In this case, a step of etching an extra film formed on the top surface (the second surface) of the recess and other surfaces (the third surface and the fourth surface) may be performed. However, even in such a case, since the extra film formed on the top surface of the recess and other surfaces (the third surface and the fourth surface) is very slight as described above, it is possible to greatly reduce a load in the step of etching the extra film, thereby greatly shortening an etching time.

On the other hand, when filling the recess with a film by a film-forming method such as performing step D in the related art, a film (SiOC) is formed on the entire side wall of the laminated structure in which the first material (SiGe) and the second material (Si) on the surface of the wafer 200 are alternately laminated, as shown in FIG. 6B. A film (SiOC) is also formed on other surfaces (the third surface and the fourth surface). At that time, voids or seams may be formed in the film due to the shape of the recess, as shown in FIG. 6B. In this case, a step of etching an extra film formed on the top surface of the recess may be performed to fill the recess with the film in the side wall of the laminated structure in which the first material and the second material are alternately laminated such that the side wall is flattened,. Further, in some cases, a film formed on other surfaces (the third surface and the fourth surface) may be etched. For example, in a case where a step of etching the extra film formed on the top surface of the recess and other surface (hereinafter, the top surface of the recess, and the like) is performed on a substrate including the structure shown in FIG. 6B on the surface of the substrate, it is possible to create a state in which no film is formed on the top surface of the recess, and the like, as shown in FIG. 6C. However, in this case, as shown in FIG. 6C, voids or seams formed in the film during film formation are maintained, and in some cases, the voids or seams become deeper due to etching, or it may not be possible to flatten the side wall of the laminated structure in which the first material and the second material are alternately laminated. Further, when a film-forming method in the related art is used, a step of etching the extra film is performed, which prolongs a total processing time, thereby lowering a productivity.

In contrast, according to the embodiments of the present disclosure, as shown in FIG. 5C, it is possible to form a void-free and seamless film in the recess while suppressing the growth of the film on the top surface of the recess, and the like. Further, when the film-forming process is completed, it is possible to fill the recess with the film (SiOC) in the side wall of the laminated structure in which the first material (SiGe) and the second material (Si) are alternately laminated, such that the sidewall may be made flat. Further, it is possible to suppress the growth of the film on other surfaces (the third surface and the fourth surface) or the like. As a result, it is possible to omit a step of removing, by etching, the extra film formed on the top surface of the recess, and the like after the film-forming process, which is performed in the film-forming method in the related art. Although an inhibitor layer is formed on the top surface of the recess, and the like, even in a case where the growth of the film starting from the top surface of the recess, and the like occurs very slightly for some reason, since the extra film formed on the top surface of the recess, and the like is very slight, it is possible to greatly reduce a load in the step of etching the extra film, thereby greatly shortening the etching time. That is, according to the embodiments of the present disclosure, it is possible to make void-free and seamless embedding, thereby improving the embedding characteristic, and greatly shorten the total processing time by omitting the step of etching the extra film or reducing the load of the step of etching the extra film, thereby greatly improving the productivity.

(e) By setting the processing temperature in step B to be equal to or higher than the processing temperature in step A, it is possible to selectively sublimate and remove an oxide formed on the first surface of the wafer 200 while leaving (maintaining) the OH termination on the second surface, the third surface, and the fourth surface of the wafer 200, thereby selectively removing the OH termination on the first surface effectively. By setting the processing temperature in step B to be higher than the processing temperature in step A, it is possible to selectively remove the OH termination on the first surface more effectively. At this time, the processing temperature in step B may be set to be equal to or higher than each of the processing temperatures in step A and step C. Further, at this time, the processing temperature in step B may be set to be higher than each of the processing temperatures in step A and step C. Further, at this time, the processing temperature in step B may be set to be equal to or higher than each of the processing temperatures in step A, step C, and step D. Further, at this time, the processing temperature in step B may be set to be higher than each of the processing temperatures in step A, step C, and step D.

For these reasons, it is possible to effectively create a state in which the amount (density or concentration) of OH termination on each of the second surface, the third surface, and the fourth surface of the wafer 200 before performing step C is larger (higher) than an amount (density or concentration) of OH termination on the first surface of the wafer 200. Further, the amount (density or concentration) of OH termination on the first surface of the wafer 200 may be zero. Accordingly, in step C, it is possible to effectively cause at least a portion of the molecular structure of molecules constituting a modifying agent to be selectively (preferentially) adsorbed at a high density on the second surface, the third surface, and the fourth surface of the wafer 200, thereby selectively (preferentially) forming a high-density inhibitor layer on these surfaces. As a result, it is possible to fill the recess with the film with high selectivity while suppressing the growth of the film on the second surface, the third surface, and the fourth surface of the wafer 200. Further, in step B, by regulating the temperature of the wafer 200, that is, by heating the wafer 200 to a predetermined temperature, it is possible to selectively sublimate and remove an oxide formed on the first surface of the wafer 200 while leaving (maintaining) the OH termination on each of the second surface, the third surface, and the fourth surface of the wafer 200, thereby selectively removing the OH termination on the first surface.

(f) By performing step F of removing the native oxide film on the surface of the wafer 200 before performing step A, it is possible to remove a native oxide film unevenly formed on the first surface, the second surface, the third surface, and the like of the wafer 200, thereby removing an OH termination unevenly formed on these surfaces. Thereafter, by performing step A, it is possible to uniformly oxidize the first surface, the second surface, the third surface, and the like of the wafer 200, thereby forming a very thin and very uniform oxide film on these surfaces. As a result, it is possible to uniformly form an OH termination on these surfaces. Further, when the fourth surface is constituted by the SiO film, an OH termination is also formed on the fourth surface. Then, by performing step B, it is possible to selectively sublimate and remove an oxide film uniformly formed on the first surface of the wafer 200 while leaving (maintaining) the OH termination uniformly formed on the second surface, the third surface, and the fourth surface of the wafer 200, thereby selectively removing the OH termination on the first surface. As a result, in step C, it is possible to cause at least a portion of the molecular structure of the molecules constituting a modifying agent to be more uniformly adsorbed on the second surface, the third surface, and the fourth surface, thereby forming an inhibitor layer more uniformly. Further, in step D, it is possible to uniformly form a film on the first surface.

(g) After step D is completed, by performing heat treatment (PT) on the film formed to fill the recess, it is possible to remove/repair impurities/defects contained in the film formed to fill the recess, and harden the film. Further, it is possible to remove and/or invalidate an inhibitor layer on the second surface, the third surface, and the fourth surface of the wafer 200, that is, an interface between the side surface of the recess and the film, the other side surface of the recess, the top surface of the recess, and the surfaces of portions other than the recess. At this time, by setting the temperature of the wafer 200 to be equal to or higher than the temperature of the wafer 200 in steps A to D, these effects may be enhanced. Further, at this time, by setting the temperature of the wafer 200 to be higher than the temperature of the wafer 200 in steps A to D, these effects may be further enhanced. Further, at this time, an inert gas or a reactive substance such as an oxidizing agent (oxidizing gas), that is, an assistant substance, may be supplied into the process chamber 201. By supplying the assistant substance during the heat treatment, the above-described effects may be enhanced. Further, at this time, the assistant substance may be supplied after being excited into a plasma state. This makes it possible to further enhance the above-described effects.

(h) When the first surface of the wafer 200 is constituted by a film containing the first element and the second surface of the wafer 200 is constituted by a film containing the second element, the above-described effects may be obtained remarkably. The first element includes a Group XIV element and the second element includes a Group XIV element. When the first surface of the wafer 200 is constituted by a Ge-containing film and the second surface of the wafer 200 is constituted by a Si-containing film, the above-described effects may be obtained more remarkably. When the first surface of the wafer 200 is constituted by a Si- and Ge-containing film and the second surface of the wafer 200 is constituted by a Si-containing film, the above-described effects may be obtained even more remarkably.

(i) When the first surface of the wafer 200 is constituted by a film containing the first element, the second surface of the wafer 200 is constituted by a film containing the second element, the third surface of the wafer 200 is constituted by a film containing the third element, and the fourth surface of the wafer 200 is constituted by a film containing the fourth element, the above-described effects may be obtained remarkably. The first element includes a Group XIV element, the second element includes a Group XIV element, the third element includes a Group XV element, and the fourth element includes a Group XVI element. When the first surface of the wafer 200 is constituted by a Ge-containing film, the second surface of the wafer 200 is constituted by a Si-containing film, the third surface of the wafer 200 is constituted by a N-containing film, and the fourth surface of the wafer 200 is constituted by an O-containing film, the above-described effects may be obtained more remarkably. When the first surface of the wafer 200 is constituted by a Si- and Ge-containing film, the second surface of the wafer 200 is constituted by a Si-containing film, the third surface of the wafer 200 is constituted by a Si- and N-containing film, and the fourth surface of the wafer 200 is constituted by a Si- and O-containing film, the above-described effects may be obtained more remarkably.

(4) Modifications

The processing sequence in the embodiments of the present disclosure may be changed as in the following modifications. These modifications may be used in proper combination. Unless otherwise stated, a processing procedure and a process condition in each step of each modification may be the same as the processing procedure and process condition in each step of the above-described substrate processing sequence.

(First Modification)

As in the processing sequence shown below, in step A, after performing steps A1 and A2, step A3 of exciting an oxidizing agent and a reducing agent into a plasma state and supplying them to the wafer 200 subjected to steps A1 and A2 may be further performed. In this case, step A further includes performing step A3. That is, step A includes performing step A1, step A2, and step A3. A processing procedure and a process condition in step A3 may be, for example, the same as those in the above-described step A1.

$$\text{Oxidizing agent}^* + \text{Reducing agent}^* \rightarrow \text{Reducing agent}^* \rightarrow \text{Oxidizing agent}^* + \text{Reducing agent}^* \rightarrow \text{Heat treatment} \rightarrow \text{Modifying agent} \rightarrow (\text{Precursor} \rightarrow \text{Reactant}) \times n$$

$$\text{Oxidizing agent}^* + \text{Reducing agent}^* \rightarrow \text{Reducing agent}^* \rightarrow \text{Oxidizing agent}^* + \text{Reducing agent}^* \rightarrow \text{Heat treatment} \rightarrow \text{Modifying agent} \rightarrow (\text{Precursor} + \text{Catalyst} \rightarrow \text{Reactant}) \times n$$

$$\text{Oxidizing agent}^* + \text{Reducing agent}^* \rightarrow \text{Reducing agent}^* \rightarrow \text{Oxidizing agent}^* + \text{Reducing agent}^* \rightarrow \text{Heat treatment} \rightarrow \text{Modifying agent} \rightarrow (\text{Precursor} \rightarrow \text{Reactant} + \text{Catalyst}) \times n$$

$$\text{Oxidizing agent}^* + \text{Reducing agent}^* \rightarrow \text{Reducing agent}^* \rightarrow \text{Oxidizing agent}^* + \text{Reducing}$$

$$\text{agent}^* \rightarrow \text{Heat treatment} \rightarrow \text{Modifying agent} \rightarrow (\text{Precursor} + \text{Catalyst} \rightarrow \text{Reactant} + \text{Catalyst}) \times$$

$$n$$

This modification may also obtain the same effects as in the above-described embodiments. Further, according to the modification, by adding step A3 in step A, it is possible to further increase the density of OH termination on the first surface, the second surface, the third surface, and the fourth surface of the wafer 200, thereby creating a state in which each surface contains a higher-density OH termination. As a result, in step C, it is possible to further increase the density of the inhibitor layer formed on the second surface, the third surface, and the fourth surface of the wafer 200, thereby further enhancing the film formation inhibiting effect (adsorption inhibiting effect or reaction inhibiting effect) of the inhibitor layer.

(Second Modification)

Depending on a surface condition of the wafer 200, step F (removal of native oxide film) may be omitted. For example, after the laminated structure including the first surface (surface of the SiGe film), the second surface (surface of the Si film), the third surface (surface of the SiN film), and the fourth surface (surface of the SiO film), as shown in FIG. 5A, is formed on the surface of the wafer 200, in a case where the surface of the wafer 200 is not subjected to an atmosphere exposure, an amount of atmosphere exposure is small, or an atmosphere exposure time is short, each surface may be in proper surface condition. In such a case, step F may be omitted, and the processing sequence may be started from step A. This modification may also obtain the same effects as in the above-described embodiments. Further, by omitting step F, it is possible to shorten the total processing time, thereby improving the productivity.

(Third Modification)

For the film formed to fill the recess, in a case where removal of impurities, repair of defects, and hardening of the film may not be performed or in a case where removal and/or invalidation of the inhibitor layer may not be performed on each surface of the wafer 200, step E may be omitted. For example, step E may be omitted when the amount of impurities, defects, and the like contained in the film formed to fill the recess is within an allowable range. Further, step E may be omitted even when an amount of residual groups or resides of an inhibitor layer on the interface between the side surface of the recess and the film, the other side surface of the recess, the top surface of the recess, and the surfaces of portions other than the recess is within an allowable range. Further, step E may be omitted when residual groups or residues of the inhibitor layer on the interface between the side surface of the recess and the film, the other side surface of the recess, the top surface of the recess, and the surfaces of portions other than the recess are removed by a reaction in the film-forming process or in a process after the film-forming process. This modification may also obtain the same effects as in the above-described embodiments. Further, by omitting step E, it is possible to shorten the total processing time, thereby improving the productivity.

<Other Embodiments of the Present Disclosure>

The embodiments of the present disclosure are specifically described above. However, the present disclosure is not limited to the above-described embodiments, and various changes may be made without departing from the gist thereof.

For example, in step F, an etching agent may be excited into a plasma and supplied to the wafer 200. As a result, an etching rate when etching a native oxide film may be increased. Further, in step B, an inert gas may be excited into a plasma and supplied. This makes it possible to sublimate and remove an oxide such as GeO formed on the first surface and, at the same time, perform plasma treatment on the first surface after the oxide is removed. Further, in step E, an inert gas or an assistant substance may be excited into a plasma and supplied. This makes it possible to more effectively remove/repair impurities/defects contained in the film formed to fill the recess, and harden the film. Further, it is possible to further enhance the effect of removing and/or invalidating the inhibitor layer on the interface between the side surface of the recess and the film, the other side surface of the recess, the top surface of the recess, and the surfaces of portions other than the recess.

Further, for example, in step D, in addition to the SiOC film and the SiO film, a silicon-based oxide film such as a silicon oxycarbonitride film (SiOCN film), a silicon oxynitride film (SiON film), a silicon borooxynitride film (SiBON film), or a silicon borooxycarbonitride film (SiBOCN film) may be formed. Further, in step D, a metal-based oxide film such as an aluminum oxide film (AIO film), a titanium oxide film (TiO film), a hafnium oxide film (HfO film), or a zirconium oxide film (ZrO film) may be formed.

Recipes used in each process may be provided individually according to the processing contents and may be stored in the memory 121c via a telecommunication line or the external memory 123. Moreover, at the beginning of each process, the CPU 121a may properly select an appropriate recipe from the recipes recorded and stored in the memory 121c according to the processing contents. Thus, it is possible for a single substrate processing apparatus to form films of various kinds, composition ratios, qualities, and thicknesses with enhanced reproducibility. Further, it is possible to reduce an operator's burden and to quickly start each process while avoiding an operation error.

The recipes mentioned above are not limited to newly-provided ones but may be provided, for example, by modifying existing recipes that are already installed in the substrate processing apparatus. When the recipes are modified, the modified recipes may be installed in the substrate processing apparatus via a telecommunication line or a recording medium storing the recipes. In addition, the existing recipes already installed in the existing substrate processing apparatus may be directly modified by operating the input/output device 122 of the substrate processing apparatus.

An example in which the film is formed by using a batch-type substrate processing apparatus capable of processing a plurality of substrates at a time is described in the above-described embodiments. The present disclosure is not limited to the above-described embodiments, but may also be suitably applied, for example, to a case where a film is formed by using a single-wafer type substrate processing apparatus capable of processing a single substrate or several substrates at a time. In addition, an example in which the film is formed by using a substrate processing apparatus including a hot-wall-type process furnace is described in the above-described embodiments. The present disclosure is not limited to the above-described embodiments, but may also be suitably applied to a case where a film is formed by using a substrate processing apparatus including a cold-wall-type process furnace.

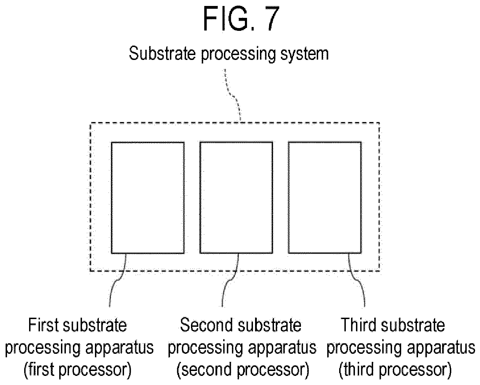

In the above-described embodiments of the present disclosure, an example in which step F and steps A to E are continuously performed (in-situ) in the same process chamber, that is, the same processor, of the same substrate processing apparatus (substrate processing system) is described. The present disclosure is not limited to the above-described embodiments, and may also be suitably applied to a case where, for example, as shown in FIG. 7, a substrate processing system including a plurality of stand-alone substrate processing apparatuses (a first substrate processing apparatus, a second substrate processing apparatus, and a third substrate processing apparatus) is used to perform each step (ex-situ) in different process chambers, that is, different processors, of respective different substrate processing apparatuses. In such a case, for example, step F may be performed in the first substrate processing apparatus, step A may be performed in the second substrate processing apparatus, and steps B to E may be performed in the third substrate processing apparatus. Further, when step A may be omitted, for example, step A may be performed in the first substrate processing apparatus, steps B to D may also be performed in the second substrate processing apparatus, and step E may also be performed in the third substrate processing apparatus. Further, when steps A and E may be omitted, for example, step A may be performed in the first substrate processing apparatus, step B may be performed in the second substrate processing apparatus, and steps C to D may be performed in the third substrate processing apparatus. Further, in such a case, for example, by using two substrate processing apparatuses, step A may be performed in the first substrate processing apparatus and steps B to D may be performed in the second substrate processing apparatus. In such a case, the first substrate processing apparatus, the second substrate processing apparatus, and the third substrate processing apparatus are also referred to as a first processor, a second processor, and a third processor, respectively. Further, the above-described embodiments of the present disclosure may be examples in which the first processor, the second processor, and the third processor are the same processor.

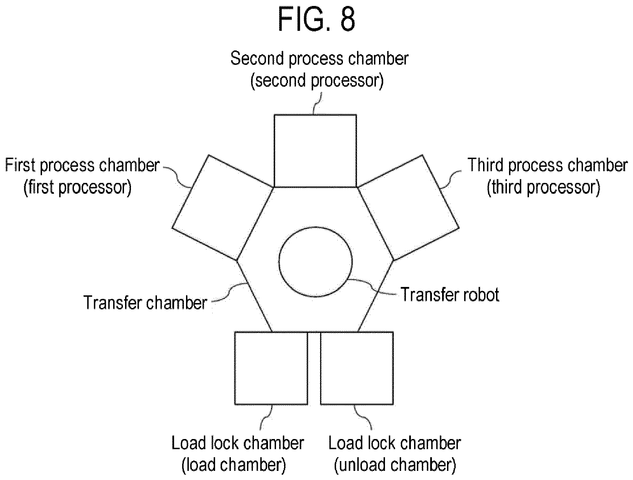

Further, the present disclosure may also be suitably applied to a case where, for example, as shown in FIG. 8, a substrate processing system including a cluster-type substrate processing apparatus provided with a plurality of process chambers (a first process chamber, a second process chamber, and a third process chamber) around a transfer chamber is used to perform the respective steps in different process chambers, that is, different processors, of the same substrate processing apparatus. In this case, for example, step F may be performed in the first process chamber, step A may be performed in the second process chamber, and steps B to E may be performed in the third process chamber. Further, when step A may be omitted, for example, step A may be performed in the first process chamber, steps B to D may be performed in the second process chamber, and step E may be performed in the third process chamber. Further, when steps A and E may be omitted, for example, step A may be performed in the first process chamber, step B may be performed in the second process chamber, and steps C to D may be performed in the third process chamber. In this case, for example, by using two process chambers, step A may be performed in the first process chamber and steps B to D may be performed in the second process chamber. In this case, the first process chamber, the second process chamber, and the third process chamber are also referred to as a first processor, a second processor, and a third processor, respectively. The above-described embodiments may also be examples in which the first processor, the second processor, and the third processor are the same processor.

Even in the case of using these substrate processing systems and substrate processing apparatuses, the respective processes may be performed according to the same processing procedures and process conditions as those in the above-described embodiments, and the same effects as the above-described embodiments may be obtained.

The above-described embodiments may be used in proper combination. The processing procedures and process conditions used in this case may be the same as, for example, the processing procedures and process conditions in the above-described embodiments.

[Examples]

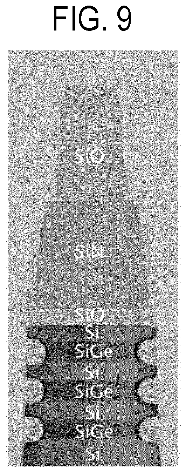

An evaluation sample 1 is provided by performing the processing sequence of the above-described embodiments on a wafer in which a laminated structure in which a SiGe film and a Si film are alternately laminated is formed on a surface of the wafer, a SiO film, a SiN film, and a SiO film are laminated on the laminated structure, and a recess whose top surface and side surface are constituted by the Si film, whose bottom surface is constituted by the SiGe film, and whose depth direction is a direction (horizontal direction) parallel to the surface of the wafer is formed in a side wall of the laminated structure including the SiGe film and the Si film to form a SiOC film so as to fill the recess, as shown in FIG. 5A. Thereafter, a cross-sectional TEM image of the evaluation sample 1 is photographed. The cross-sectional TEM image of the evaluation sample 1 is shown in FIG. 9.

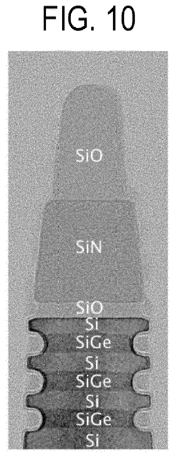

An evaluation sample 2 is provided by performing the processing sequence in the above-described first modification on a wafer including the same structure as the wafer used when providing the evaluation sample 1 to form a SiOC film to fill the recess. Thereafter, a cross-sectional TEM image of the evaluation sample 2 is photographed. The cross-sectional TEM image of the evaluation sample 2 is shown in FIG. 10.

As shown in FIGS. 9 and 10, in both the evaluation sample 1 and the evaluation sample 2, it is confirmed that the SiOC film is selectively formed in the recess without being formed on the top surface (surface of the Si film) of the recess and other surfaces (surfaces of the SiN film and the SiO film). Further, in both the evaluation sample 1 and the evaluation sample 2, it is confirmed that the recess is filled with the SiOC film in the side wall of the laminated structure in which the SiGe film and the Si film are alternately laminated, such that the side wall may be made flat. Further, in both the evaluation sample 1 and the evaluation sample 2, it is confirmed that no voids or seams occurs in the SiOC film with which the recess is filled. Further, in both the evaluation sample 1 and the evaluation sample 2, it is confirmed that plasma damage does not occur in any of the SiGe film, the Si film, the SiN film, and the SiO film on the surface of the wafer.

According to the present disclosure in some embodiments, it is possible to selectively form a film on a desired surface with high precision.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. A method of processing a substrate, comprising:

   (a) performing: (a1) exciting a first oxidizing agent and a first reducing agent into a plasma state and supplying the first oxidizing agent and the first reducing agent thus excited to the substrate, which includes a first surface and a second surface; and (a2) exciting a second reducing agent into a plasma state and supplying the second reducing agent thus excited to the substrate; and
   (b) heat-treating the substrate subjected to (a).

2. The method of Claim 1, further comprising (c) forming an inhibitor layer on the second surface by supplying a modifying agent to the substrate subjected to (b).

3. The method of Claim 2, further comprising (d) forming a film on the first surface by supplying a film-forming agent to the substrate subjected to (c).

4. The method of Claim 1, wherein (a) further includes performing (a3) exciting a second oxidizing agent and a third reducing agent into a plasma state and supplying the second oxidizing agent and the third reducing agent thus excited to the substrate subjected to (a1) and (a2).

5. The method of Claim 1, wherein a processing temperature in (b) is equal to or higher than a processing temperature in (a).

6. The method of Claim 2, wherein a processing temperature in (b) is equal to or higher than each of processing temperatures in (a) and (c).

7. The method of Claim 1, wherein in (a), an OH termination is formed on the first surface and the second surface, and in (b), the OH termination formed on the first surface is removed while leaving the OH termination formed on the second surface.

8. The method of Claim 1, wherein the substrate further includes at least one selected from the group of a third surface and a fourth surface, and
wherein in (a), an OH termination is formed on the first surface, the second surface, and the at least one selected from the group of the third surface and the fourth surface, and in (b), the OH termination formed on the first surface is removed while leaving the OH termination formed on the second surface and the at least one selected from the group of the third surface and the fourth surface..

9. The method of any one of Claims 1 to 7, wherein the first surface is constituted by a germanium-containing film, and the second surface is constituted by a silicon-containing film.

10. The method of Claim 8, wherein the first surface is constituted by a germanium-containing film, the second surface is constituted by a silicon-containing film, the third surface is constituted by a nitrogen-containing film, and the fourth surface is constituted by an oxygen-containing film.

11. The method of any one of Claims 1 to 7, wherein a recess is formed on a surface of the substrate, the first surface is a bottom surface of the recess, and the second surface is a side surface of the recess or the side surface and a top surface of the recess.

12. The method of Claim 8, wherein a recess is formed on a surface of the substrate, the first surface is a bottom surface of the recess, the second surface is a side surface of the recess or the side surface and a top surface of the recess, and the third surface and the fourth surface are surfaces of portions of the surface of the substrate other than the recess.

13. A method of manufacturing a semiconductor device, comprising the method of Cla im 1.

14. A substrate processing system configured to process a substrate, comprising:

an oxidizing agent supply system configured to supply an oxidizing agent to the su bstrate;
a reducing agent supply system configured to supply a first reducing agent and a se cond reducing agent to the substrate;
a plasma exciter configured to excite the oxidizing agent, the first reducing agent, a nd the second reducing agent into a plasma state;
a heater configured to heat the substrate; and
a controller configured to be capable of controlling the oxidizing agent supply syste m, the reducing agent supply system, and the heater so as to perform:

(a) performing: (a1) exciting the oxidizing agent and the first reducing agent into t he plasma state and supplying the oxidizing agent and the first reducing agent thus excit ed to the substrate, which includes a first surface and a second surface; and (a2) exciting the second reducing agent into the plasma state and supplying the second reducing agen t thus excited to the substrate; and
(b) heat-treating the substrate subjected to (a).

15. A program that causes, by a computer, a substrate processing system to perform:

(a) performing: (a1) exciting an oxidizing agent and a first reducing agent into a pl asma state and supplying the oxidizing agent and the first reducing agent thus excited to a substrate, which includes a first surface and a second surface; and (a2) exciting a secon d reducing agent into a plasma state and supplying the second reducing agent thus excite d to the substrate; and
(b) heat-treating the substrate subjected to (a).

# FIG. 1

# FIG. 2

# FIG. 3

248

121

121a
CPU

121b
RAM

123
External memory

121c
Memory

122
Input/output device

121d
I/O port

121e

MFC ~ 241a~241h

Valve ~ 243a~243h

Pressure sensor ~ 245

APC valve ~ 244

Vacuum pump ~ 246

Heater ~ 207

Temperature sensor ~ 263

....

Rotator ~ 267

Boat elevator ~ 115

Shutter opening/closing equipment ~ 115s

RPU ~ 300

FIG. 4

Lowering temperature

Raising temperature

| | F | A | B | C | D | E |

| | P | A1 | P | A2 | P | P | 1st cycle | 2nd cycle | nth cycle | P | P |

Modifying agent

Precursor

Reactant

Catalyst

Inert gas

Etching agent

Oxidizing agent

Reducing agent

RF power

Processing temperature

EP 4 343 816 A1

# FIG. 5A

# FIG. 5B

## FIG. 5C

SiO

SiN — Inhibitor layer

SiO

Si

SiOC — SiGe — SiOC

Si

SiOC — SiGe — SiOC

Si

SiOC — SiGe — SiOC

200

# FIG. 5D

# FIG. 6A

Top surface
Side surface
Bottom surface
Recess

SiO
SiN
SiO
Si
SiGe
Si
SiGe
Si
SiGe
200

# FIG. 6B

# FIG. 6C

# FIG. 7

Substrate processing system

First substrate
processing apparatus
(first processor)

Second substrate
processing apparatus
(second processor)

Third substrate
processing apparatus
(third processor)

# FIG. 8

Second process chamber
(second processor)

First process chamber
(first processor)

Third process chamber
(third processor)

Transfer chamber

Transfer robot

Load lock chamber
(load chamber)

Load lock chamber
(unload chamber)

FIG. 9

# FIG. 10

Europäisches
Patentamt

European
Patent Office

Office européen
des brevets

**EUROPEAN SEARCH REPORT**

Application Number

EP 23 19 7771

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/280418 A1 (ZHANG XINMING [US] ET AL) 9 September 2021 (2021-09-09) * paragraphs [0018] - [0055]; figures 1-5 * | 1,4,5, 11,13-15 | INV. H01L21/02 H01L21/32 |
| X | US 2018/366317 A1 (KE CHANG [US] ET AL) 20 December 2018 (2018-12-20) * paragraphs [0021] - [0090]; figures 1-9 * | 1-15 | ADD. H01L21/30 H01L21/3105 |
| X | US 2020/006057 A1 (AZUMO SHUJI [JP]) 2 January 2020 (2020-01-02) * paragraphs [0028] - [0043]; figures 1,2 * | 1-15 | |
| A | US 9 484 406 B1 (SUN SHIYU [US] ET AL) 1 November 2016 (2016-11-01) * the whole document * | 1-15 | |
| A | US 2018/315771 A1 (SANDHU GURTEJ S [US] ET AL) 1 November 2018 (2018-11-01) * the whole document * | 1-15 | |

TECHNICAL FIELDS SEARCHED (IPC)

H01L

The present search report has been drawn up for all claims

| Place of search | Date of completion of the search | Examiner |
|---|---|---|
| The Hague | 10 February 2024 | Simeonov, Dobri |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 4 343 816 A1

## ANNEX TO THE EUROPEAN SEARCH REPORT
## ON EUROPEAN PATENT APPLICATION NO.

EP 23 19 7771

This annex lists the patent family members relating to the patent documents cited in the above-mentioned European search report.
The members are as contained in the European Patent Office EDP file on
The European Patent Office is in no way liable for these particulars which are merely given for the purpose of information.

10-02-2024

| Patent document cited in search report | | | Publication date | Patent family member(s) | | | Publication date |
|---|---|---|---|---|---|---|---|
| US 2021280418 | A1 | | 09-09-2021 | CN | 114667591 | A | 24-06-2022 |
| | | | | JP | 2023507060 | A | 21-02-2023 |
| | | | | KR | 20220092926 | A | 04-07-2022 |
| | | | | KR | 20230161540 | A | 27-11-2023 |
| | | | | TW | 202141629 | A | 01-11-2021 |
| | | | | US | 2021280418 | A1 | 09-09-2021 |
| | | | | US | 2021280428 | A1 | 09-09-2021 |
| | | | | WO | 2021178123 | A1 | 10-09-2021 |
| US 2018366317 | A1 | | 20-12-2018 | TW | 201905971 | A | 01-02-2019 |
| | | | | US | 2018366317 | A1 | 20-12-2018 |
| | | | | US | 2020402792 | A1 | 24-12-2020 |
| | | | | WO | 2018232103 | A1 | 20-12-2018 |
| US 2020006057 | A1 | | 02-01-2020 | JP | 7101551 | B2 | 15-07-2022 |
| | | | | JP | 2020002452 | A | 09-01-2020 |
| | | | | KR | 20200004245 | A | 13-01-2020 |
| | | | | TW | 202014547 | A | 16-04-2020 |
| | | | | US | 2020006057 | A1 | 02-01-2020 |
| US 9484406 | B1 | | 01-11-2016 | NONE | | | |
| US 2018315771 | A1 | | 01-11-2018 | CN | 110574161 | A | 13-12-2019 |
| | | | | EP | 3616240 | A1 | 04-03-2020 |
| | | | | JP | 6890189 | B2 | 18-06-2021 |
| | | | | JP | 2020518135 | A | 18-06-2020 |
| | | | | KR | 20190135540 | A | 06-12-2019 |
| | | | | SG | 11201909899S | A | 28-11-2019 |
| | | | | TW | 201843775 | A | 16-12-2018 |
| | | | | US | 9985049 | B1 | 29-05-2018 |
| | | | | US | 2018315771 | A1 | 01-11-2018 |
| | | | | WO | 2018200133 | A1 | 01-11-2018 |

EPO FORM P0459

For more details about this annex : see Official Journal of the European Patent Office, No. 12/82

**EP 4 343 816 A1**

**Patent documents cited in the description**

- JP 2022152708 A